# FASCICULE DE BREVET EUROPEEN

(11) **EP 4 362 101 B1**
(45) Date de publication et mention de la délivrance du brevet: **30.07.2025**
(21) Numéro de dépôt: 23205735.6
(22) Date de dépôt: 25.10.2023
(51) Int. Cl.: H10H 29/01, H10H 29/30, H01S 5/42

(54) **SUBSTRAT DE CROISSANCE DE MATRICE DE DIODES, COMPORTANT DES MESAS PRESENTANT DIFFERENTS NIVEAUX DE POROSIFICATION**
DIODENMATRIXWACHSTUMSSUBSTRAT MIT MESAS MIT VERSCHIEDENEN PORENBILDUNGSEBENEN
DIODE ARRAY GROWTH SUBSTRATE WITH MESAS HAVING DIFFERENT POROSIFICATION LEVELS

(30) Priorité: 28.10.2022 FR 2211333
(43) Date de publication de la demande: 01.05.2024
(73) Titulaire: Commissariat à l'Energie Atomique et aux Energies Alternatives, 75015 Paris (FR)
(72) Inventeur: DUPRE, Ludovic, 38054 Grenoble cedex 09 (FR); DUSSAIGNE, Amélie, 38054 Grenoble cedex 09 (FR); PERNEL, Carole, 38054 Grenoble cedex 09 (FR); ROL, Fabian, 38054 Grenoble cedex 09 (FR)
(74) Mandataire: Brevalex

(56) Documents cités:
- EP-A1- 3 840 016
- EP-A1- 3 840 065
- US-A1- 2022 208 848

## Description

### DOMAINE TECHNIQUE

Le domaine de l'invention est celui des substrats de croissance comportant des mésas permettant la fabrication d'une matrice de diodes adaptées à émettre ou à détecter, de manière native, un rayonnement lumineux à différentes longueurs d'onde.

### ÉTAT DE LA TECHNIQUE ANTÉRIEURE

Il existe des procédés de fabrication d'une matrice de diodes électroluminescentes adaptée à émettre, de manière native, un rayonnement lumineux à différentes longueurs d'onde. La matrice de diodes peut alors comporter des diodes adaptées à émettre une lumière rouge, d'autres diodes une lumière verte, et d'autres enfin une lumière bleue. Une telle matrice de diodes forme alors un micro-écran à émission native RGB (pour *Red, Green, Blue,* en anglais).

Les diodes sont dites à émission native, dans le sens où la zone active de chaque diode émettant à une longueur d'onde donnée diffère des zones actives des diodes émettant à une autre longueur d'onde. Dans le cas des diodes réalisées à base d'InGaN, les zones actives diffèrent les unes des autres par la proportion d'indium dans les puits quantiques.

Une telle matrice de diodes à émission native se distingue ainsi des technologies à conversion de couleurs où les diodes émettent toutes à une même longueur d'onde, par exemple dans le bleu, et sont revêtues chacune d'un plot comportant des luminophores, par exemple des nanocristaux semiconducteurs formant des boîtes quantiques, pour convertir au moins en partie la lumière incidente en une lumière d'une autre longueur d'onde.

Pour fabriquer une matrice de diodes à émission native, une approche consiste à utiliser un substrat de croissance présentant des mésas ayant été en partie rendues poreux lors d'une étape de porosification électrochimique. Cette technique de porosification électrochimique est présentée notamment dans l'article de Griffin et Oliver intitulé Porous nitride semiconductors reviewed, J. Phys. D : Appl. Phys. 53 (2020) 383002.

Le document EP3840065A1 décrit un exemple de procédé de fabrication d'un substrat de croissance puis d'une matrice de diodes utilisant la technique de porosification électrochimique. Le procédé comporte la réalisation d'un substrat de croissance (également appelé pseudo-substrat) présentant plusieurs mésas en InGaN, formées chacune d'une couche dopée en InGaN rendue poreux lors d'une étape de porosification électrochimique, et d'une couche supérieure en InGaN non intentionnellement dopé ou faiblement dopé de sorte qu'il ne soit pas porosifié (i.e. il reste intègre ou dense, donc non poreux). Les diodes sont ensuite réalisées par reprise d'épitaxie à partir de la couche supérieure.

EP 3 840 016 A1 et US 2022/208848 A1 divulguent des substrats de croissance comprenant des mésas selon l'art antérieur.

Les couches dopées des mésas peuvent présenter des niveaux de dopage différents d'une mésa à l'autre, ce qui conduit à une porosification différente et donc à un taux de relaxation différent. Les diodes réalisées à partir des différentes mésas comportent alors des puits quantiques ayant une proportion d'indium plus ou moins importante, permettant ainsi d'obtenir des pixels émissifs à différentes longueurs d'onde.

Cependant, pour obtenir des mésas dont les couches dopées en InGaN présentent différents niveaux de dopage d'une mésa à l'autre, il est nécessaire d'effectuer, avant l'étape de réalisation des mésas, une étape d'implantation localisée de dopants dans une couche d'InGaN pleine plaque, avec différents niveaux de dopage, ce qui peut complexifier le procédé de fabrication.

### EXPOSÉ DE L'INVENTION

L'invention a pour objectif de remédier au moins en partie aux inconvénients de l'art antérieur, et plus particulièrement de proposer un substrat de croissance, et son procédé de fabrication, pour la fabrication d'une matrice de diodes adaptées à émettre ou détecter, de manière native, un rayonnement lumineux à différentes longueurs d'onde. Ce substrat de croissance peut être fabriqué par un procédé simplifié par rapport à celui de l'art antérieur décrit précédemment, en ce qu'il ne comporte pas d'étapes d'implantation localisée de dopants avant la réalisation des mésas.

Pour cela, l'objet de l'invention est un substrat de croissance adapté à la réalisation par épitaxie d'une matrice de diodes à base d'InGaN, comportant :
∘ une couche inférieure d'isolation réalisée en un matériau cristallin non poreux à base de GaN ;
∘ des mésas M₍ᵢ₎, avec i allant de 0 à N, réalisées en des matériaux cristallins à base de GaN, reposant sur et au contact de la couche inférieure d'isolation, et comportant chacune N couches dopées, avec N≥2, séparées deux à deux par une couche intermédiaire d'isolation réalisée en un matériau non poreux, et présentant chacune une face supérieure libre adaptée à la réalisation par épitaxie d'une diode de la matrice ; les mésas étant configurées selon au moins trois catégories différentes parmi lesquels :
   - une catégorie de mésas dite M_{(N)} où les N couches dopées sont poreuses ;
   - une catégorie de mésas dite M₍₀₎ où aucune des couches dopées n'est poreuse ;
   - une catégorie de mésas dite M₍ₙ₎ où n couches dopées sont poreuses, avec 1≤n<N.

Chaque mésa M₍ᵢ₎ peut comporter une couche de reprise d'épitaxie reposant sur une couche dopée supérieure parmi les N couches dopées, réalisée en un matériau cristallin non poreux à base d'InGaN dont le paramètre de maille a^{m}_{cre} du matériau relaxé est supérieur au paramètre de maille effectif a^{e}_{cii} de la couche inférieure d'isolation :
∘ la couche de reprise d'épitaxie de chaque mésa M_{(N)} présentant un paramètre de maille maximal a^{e}_{cre(N)} ;
∘ la couche de reprise d'épitaxie de chaque mésa M₍₀₎ présentant un paramètre de maille a^{e}_{cre(0)} inférieur à a^{e}_{cre(N)};
∘ la couche de reprise d'épitaxie de chaque mésa M₍ₙ₎ présentant un paramètre de maille intermédiaire a^{e}_{cre(n)} inférieur à a^{e}_{cre(N)} et différent de a^{e}_{cre(0)}.

La couche intermédiaire d'isolation de chaque mésa peut présenter une épaisseur inférieure à celle des couches dopées adjacentes.

La couche intermédiaire d'isolation de chaque mésa peut présenter une épaisseur comprise entre 10nm et 100nm.

La couche inférieure d'isolation et la couche intermédiaire d'isolation peuvent présenter un niveau de dopage au plus égal à 5x10¹⁷ cm⁻³. De préférence, la couche intermédiaire d'isolation est non intentionnellement dopée.

Les couches dopées sont de préférence dopées de type n.

Les couches dopées inférieures des mésas M₍ᵢ₎ peuvent être réalisées en le même matériau et peuvent présenter la même épaisseur d'une mésa à l'autre. Les couches intermédiaires d'isolation des mésas M₍ᵢ₎ peuvent être réalisées en le même matériau et peuvent présenter la même épaisseur d'une mésa à l'autre. Les couches dopées supérieures des mésas M₍ᵢ₎ peuvent être réalisées en le même matériau et peuvent présenter la même épaisseur d'une mésa à l'autre.

L'invention porte également sur un dispositif optoélectronique comportant un substrat de croissance selon l'une quelconque des caractéristiques précédentes ; et une matrice de diodes D₍ᵢ₎ à base d'InGaN, épitaxiées à partir des mésas du substrat de croissance, les diodes étant adaptées à émettre ou à détecter un rayonnement lumineux à différentes longueurs d'onde, la longueur d'onde étant différente d'une catégorie de mésas M₍ᵢ₎ à l'autre.

Le dispositif optoélectronique peut former un micro-écran RGB où les diodes D₍ᵢ₎ sont des diodes électroluminescentes configurées pour émettre un rayonnement lumineux au moins dans le bleu et le rouge.

L'invention porte également sur un procédé de fabrication d'un substrat de croissance selon l'une quelconque des caractéristiques précédentes, comportant les étapes suivantes :
∘ détermination d'une valeur d'une tension électrique à appliquer lors d'une étape ultérieure de porosification électrochimique ;
∘ réalisation d'un empilement cristallin, comportant, de bas en haut : une couche continue inférieure d'isolation réalisée en un matériau cristallin à base de GaN et non porosifiable à ladite valeur prédéterminée de la tension électrique à appliquer ; N couches continues dopées, avec N≥2, réalisées en des matériaux cristallins à base de GaN et porosifiables à ladite valeur prédéterminée de la tension électrique à appliquer ; au moins une couche continue intermédiaire d'isolation, séparant les couches continues dopées deux à deux, réalisée en un matériau cristallin à base de GaN et non porosifiable à ladite valeur prédéterminée de la tension électrique à appliquer ;
∘ gravure localisée de l'empilement cristallin, de manière à former lesdites mésas M₍ᵢ₎ ;
∘ réalisation de plusieurs électrodes, au contact des couches dopées à porosifier selon les différentes catégories de mésas M₍ᵢ₎;
∘ porosification électrochimique simultanée desdites couches dopées à porosifier, par application aux couches dopées à porosifier de la valeur prédéterminée de la tension électrique.

Le matériau de la couche continue inférieure d'isolation et le matériau de la couche continue intermédiaire d'isolation peuvent présenter un niveau de dopage inférieur à une valeur minimale prédéfinie à partir de laquelle ils peuvent être porosifiés compte tenu de la valeur prédéterminée de la tension électrique appliquée lors de l'étape de porosification.

Le procédé de fabrication peut comporter les étapes suivantes :
∘ à la suite de l'étape de porosification, retrait des électrodes, puis dépôt conforme d'une couche mince isolante recouvrant les mésas ;
∘ dépôt d'une couche épaisse de remplissage, remplissant les espaces entre les mésas, et amincissement de la couche épaisse de remplissage de manière à rendre libre une portion supérieure de la couche mince isolante recouvrant une surface supérieure des mésas M₍ᵢ₎ ;
∘ gravure sélective de la portion supérieure de la couche mince isolante, de manière sélective aux mésas M₍ᵢ₎, rendant libre la surface supérieure de celles-ci.

L'empilement cristallin peut comprendre une couche continue de reprise d'épitaxie à base d'InGaN, reposant sur une couche continue dopée supérieure parmi les N couches continues dopées.

Après l'étape de porosification, une couche de reprise d'épitaxie à base d'InGaN peut être réalisée sur une couche dopée supérieure parmi les N couches dopées de chaque mésa M₍ᵢ₎.

L'invention porte également sur un procédé de fabrication d'un dispositif optoélectronique selon l'une quelconques des caractéristiques précédentes, comportant les étapes suivantes :
∘ fabrication du substrat de croissance par le procédé selon l'une quelconque des caractéristiques précédentes ; puis
∘ réalisation d'une matrice de diodes D₍ᵢ₎ par épitaxie à partir des mésas M₍ᵢ₎ du substrat de croissance, les diodes étant alors adaptées à émettre ou à détecter un rayonnement lumineux à différentes longueurs d'onde, la longueur d'onde étant différente d'une catégorie de mésas M₍ᵢ₎ à l'autre.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique et partielle, en coupe transversale, d'un dispositif optoélectronique selon un mode de réalisation, comportant un substrat de croissance et une matrice de diodes ;
la figure 1B est une vue schématique et partielle, en coupe transversale, d'un substrat de croissance selon une première variante de réalisation ;
la figure 1C est une vue schématique et partielle, en coupe transversale, d'un substrat de croissance selon une deuxième variante de réalisation ;
la figure 2 illustre un exemple de relation entre le niveau de dopage d'une couche cristalline dopée en fonction de la tension électrique appliquée, mettant en évidence le domaine d'existence de la porosification électrochimique ;
les figures 3A à 3C sont des vues schématiques et partielles, en vue de dessus (fig.3A), en coupe transversale (fig.3B), et en perspective (fig.3C) d'un substrat de croissance selon une variante de réalisation ;
les figures 4A et 4B sont des vues schématiques et partielles, en coupe transversale (fig.4A) et en perspective (fig.4B), d'un substrat de croissance selon une autre variante de réalisation ;
les figures 5A à 5H illustrent différentes étapes d'un procédé de fabrication d'un dispositif optoélectronique comportant un substrat de croissance similaire à celui de la fig.1B, où la couche de reprise d'épitaxie est réalisée avant l'étape de porosification électrochimique ;
les figures 6A à 6D illustrent différentes étapes d'un procédé de fabrication d'un dispositif optoélectronique comportant un substrat de croissance similaire à celui de la fig.1B, où la couche de reprise d'épitaxie est réalisée après l'étape de porosification électrochimique.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un substrat de croissance adapté à la fabrication par épitaxie d'une matrice de diodes à base d'InGaN, les diodes permettant d'émettre ou de détecter, de manière native, un rayonnement lumineux à différentes longueurs d'onde. Il porte également sur un dispositif optoélectronique comportant le substrat de croissance et la matrice de diodes. Il porte enfin sur des procédés de fabrication du substrat de croissance et du dispositif optoélectronique.

Le dispositif optoélectronique peut être un micro-écran à émission native, par exemple de type RGB. Les diodes peuvent être des diodes électroluminescentes ou des diodes laser. En variante ou en complément, le dispositif optoélectronique peut être un dispositif de détection, les diodes étant alors des photodétecteurs.

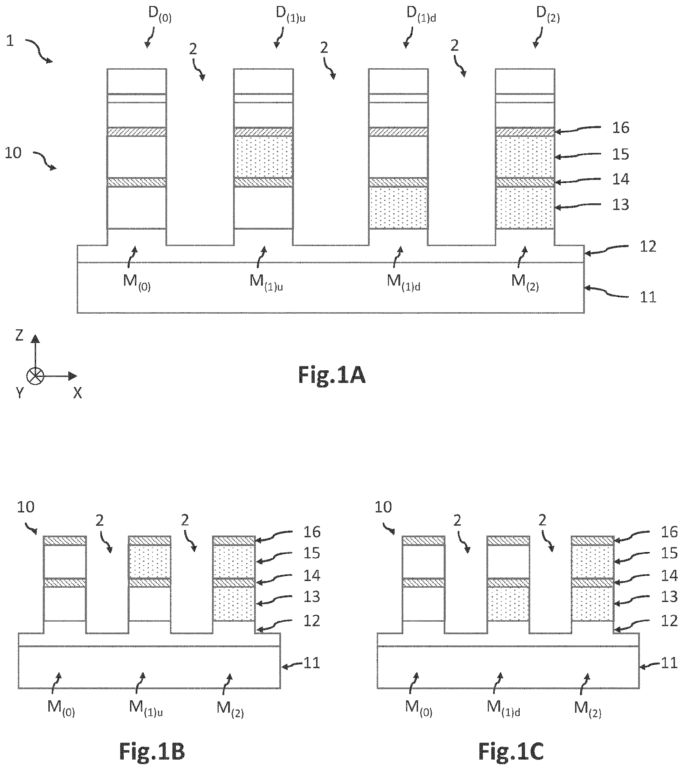

La figure 1A est une vue schématique et partielle d'un dispositif optoélectronique 1, selon un mode de réalisation. Le dispositif optoélectronique 1 est ici un micro-écran à émission native RGB, où le pas des diodes D₍ᵢ₎ peut être inférieur ou égal à 10µm environ. L'indice i, allant de 0 à N, est relatif aux catégories (présentées plus loin) des mésas M₍ᵢ₎ et donc des diodes D₍ᵢ₎. La figure 1B illustre une première variante de réalisation où le substrat de croissance 10 comporte les types de mésas M₍₀₎, M₍₁₎ᵤ et M₍₂₎, et la figure 1C illustre une deuxième variante de réalisation où le substrat de croissance 10 comporte les types de mésas M₍₀₎, M_{(1)d} et M₍₂₎.

On définit ici et pour la suite de la description un repère direct tridimensionnel orthogonal XYZ, où les axes X et Y forment un plan principal d'une couche support 11, 12, et où l'axe Z est orienté suivant l'épaisseur du substrat de croissance 10, en direction des diodes D₍ᵢ₎.

Le dispositif optoélectronique 1 comporte, d'une manière générale, un substrat de croissance 10 à partir duquel une matrice de diodes D₍ᵢ₎ a été réalisée par épitaxie. Les électrodes de polarisation électrique des diodes ne sont pas représentées ici dans un souci de clarté.

Le substrat de croissance 10 comporte, d'une manière générale, une couche support formée ici d'un substrat support 11 et d'une couche inférieure d'isolation 12, et des mésas M₍ᵢ₎ destinées chacune à la réalisation par reprise d'épitaxie d'une diode D₍ᵢ₎ de la matrice. Une mésa (i.e. une élévation, un relief) est une partie du substrat de croissance 10 en saillie vis-à-vis de la couche support. Les mésas sont réalisées par gravure localisée d'un empilement cristallin initial.

Le substrat de croissance 10 est réalisé à partir de GaN cristallin, c'est-à-dire qu'il est réalisé en GaN et/ou en ses composés tels que l'InₓGa₁₋ₓN, l'Al_{y}Ga_{1-y}N, voire l'InₓAl_{y}Ga_{1-x-y}N. Plus précisément, les mésas M₍ᵢ₎ comportent N couches dopées 13, 15 séparées deux à deux par une couche intermédiaire d'isolation 14. Une couche de reprise d'épitaxie 16, qui peut être réalisée avant ou après l'étape de porosification électrochimique, repose sur la couche dopée supérieure 15.

D'une manière générale, par matériau à base de GaN, on entend que le matériau peut être du GaN et/ou ses composés. Il peut ainsi être de l'InₓAl_{y}Ga_{1-x-y}N où la proportion d'indium x peut être nulle et où la proportion d'aluminium y peut également être nulle. Et par matériau à base d'InGaN, on entend qu'il est en InGaN ou en InAlGaN. Il peut ainsi être réalisé en l'InₓAl_{y}Ga_{1-x-y}N où la proportion d'indium x est non nulle et où la proportion d'aluminium y peut être nulle.

Les mésas M₍ᵢ₎ sont classées en différentes catégories, selon qu'elles comportent, ou non, une ou plusieurs couches dopées poreuses. Comme expliqué plus loin, certaines couches dopées sont rendues poreuses lors d'une même étape de porosification électrochimique du procédé de fabrication. Les différentes catégories sont appelées M₍ᵢ₎, avec i allant de 0 à N, selon que la mésa comporte 0, 1, 2... N couches dopées poreuses. Dans cet exemple, N est égal à 2.

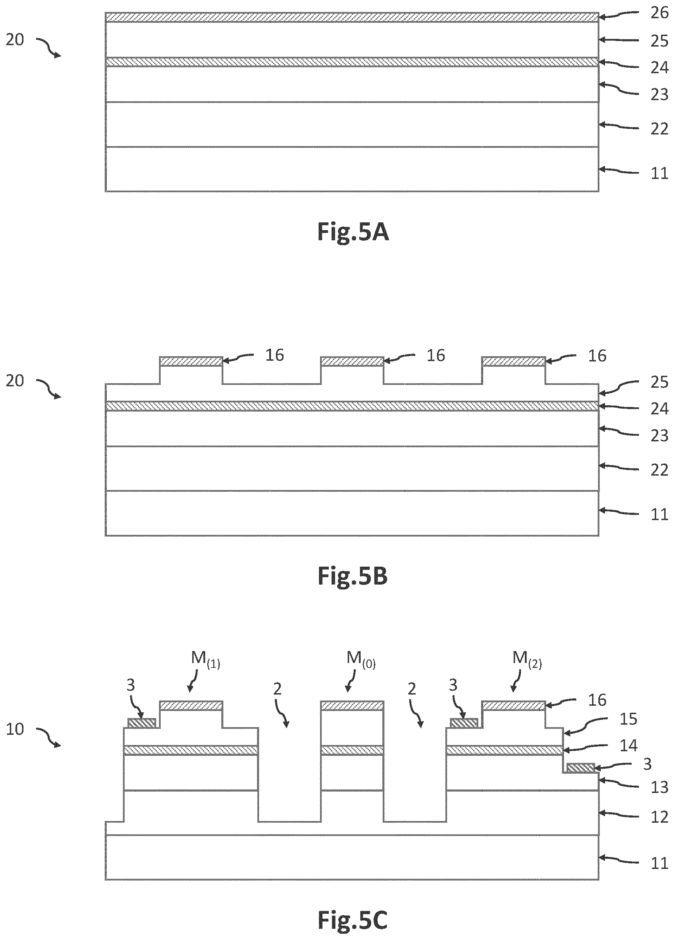

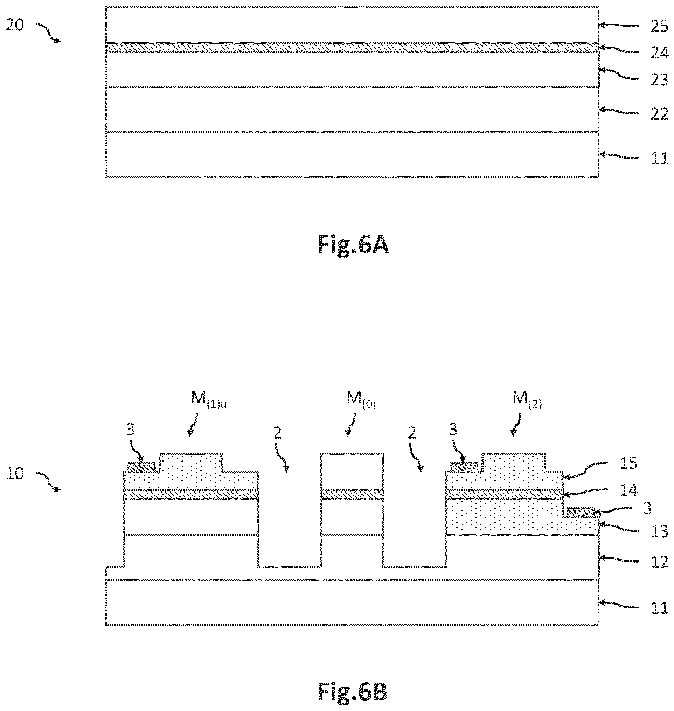

Chaque mésa M₍ᵢ₎ est obtenue par gravure localisée de l'empilement cristallin initial 20 (cf. fig.5A ou fig.6A), et comporte les N couches dopées 13, 15 (issues des couches continues 23, 25) séparées deux à deux par une couche intermédiaire d'isolation 14 (issue de la couche continue 24), et, dans cet exemple, se termine suivant la direction +Z par la couche de reprise d'épitaxie 16 (issue de la couche continue 26, cf. fig.5A) qui forme la face supérieure F₍ᵢ₎ de la mésa M₍ᵢ₎. Les mésas M₍ᵢ₎ peuvent avoir été formées par une ou plusieurs opérations de gravure, par exemple par gravure sèche, de sorte que leurs flancs peuvent être sensiblement verticaux.

Les différentes catégories M₍ᵢ₎ de mésas se distinguent entre elles par des niveaux de porosification P₍ᵢ₎ différents d'une catégorie de mésas à l'autre, qui autorisent alors des taux de relaxation R₍ᵢ₎ différents. Un niveau de porosification P₍ᵢ₎ est défini par le nombre de couches dopées 13, 15 poreuses que comporte la mésa M₍ᵢ₎ considérée. Les mésas M₍ᵢ₎ du substrat de croissance 10 sont configurées de manière à former au moins trois catégories différentes parmi lesquels :
- une catégorie M_{(N)} où toutes les couches dopées 13, 15 sont poreuses, le niveau de porosification, noté P_{(N)}, est maximal, et autorise alors un taux de relaxation maximal R_{(N)}. La couche de reprise d'épitaxie 16 présente alors un paramètre de maille effectif maximal a^{e}_{cre(N)} sensiblement égal à la valeur de son matériau massif a^{m}_{cre};
- une catégorie M₍₀₎ où aucune des couches dopées 13, 15 n'est poreuse, le niveau de porosification, noté P₍₀₎, est minimal, et autorise alors un taux de relaxation minimal R₍₀₎. La couche de reprise d'épitaxie 16 présente alors un paramètre de maille effectif a^{e}_{cre(0)} inférieur à a^{e}_{cre(N)}, et sensiblement égal au paramètre de maille effectif de la couche inférieure d'isolation a^{e}_{cii};
- une catégorie M₍ₙ₎ où n couches dopées 13, 15 sont poreuses, avec 1≤n<N, le niveau de porosification, noté P₍ₙ₎, est intermédiaire et autorise alors un taux de relaxation intermédiaire R₍ₙ₎ compris entre R₍₀₎ et R_{(N)}. La couche de reprise d'épitaxie 16 présente alors un paramètre de maille effectif a^{e}_{cre(n)} inférieur à la valeur maximale a^{e}_{cre(N)} et différent de la valeur a^{e}_{cre(0)}.

Le taux de relaxation R₍ᵢ₎ d'une mésa M₍ᵢ₎ dépend du niveau de porosification P₍ᵢ₎ et des paramètres de maille des couches dopées non poreuses des mésas. Les taux de relaxation R₍ᵢ₎ se traduisent par le fait que les couches de reprise d'épitaxie 16 présentent différentes valeurs du paramètre de maille effectif, d'une catégorie de mésa à l'autre. Aussi, les diodes D₍ᵢ₎, réalisées lors d'une même étape de reprise d'épitaxie, présentent des zones actives différentes, en termes de proportion d'indium incorporé dans les puits quantiques, d'une catégorie de diodes D₍ᵢ₎ à l'autre (et donc de mésas) et seront donc adaptées à émettre ou détecter un rayonnement lumineux à différentes longueurs d'onde.

Dans le cadre de l'invention, une couche dopée 13, 15 d'une mésa M₍ᵢ₎ peut être rendue poreuse lors de l'étape de porosification électrochimique mise en œuvre dans le procédé de fabrication du substrat de croissance 10. La couche dopée passe alors d'une structure initiale dite dense (état initial non poreux) à une structure poreuse (état final poreux). Cette porosification se traduit par la présence de pores qui s'étendent dans le volume de la couche à partir de sa surface libre (ayant été en contact avec un électrolyte liquide), comme décrit dans l'article de Griffin et Oliver 2020 cité précédemment. La porosification d'une couche dopée peut être ajustée en fonction du niveau de dopage N_{D} de celle-ci, et des conditions opératoires lors de l'étape de porosification électrochimique (nature et/ou concentration de l'électrolyte, tension électrique Eₚ appliquée, durée de porosification...). La porosification de la couche peut être définie par un taux de porosité (rapport du volume des pores sur le volume total de la couche) et par la taille moyenne des pores. Notons que l'état poreux ou non poreux d'une couche dopée peut être caractérisé au moyen d'un système de caractérisation tel qu'un système d'imagerie MEB (microscopie électronique à balayage) ou un système de mesure directe de type ellipsométrie ou ellipso-porosimétrie.

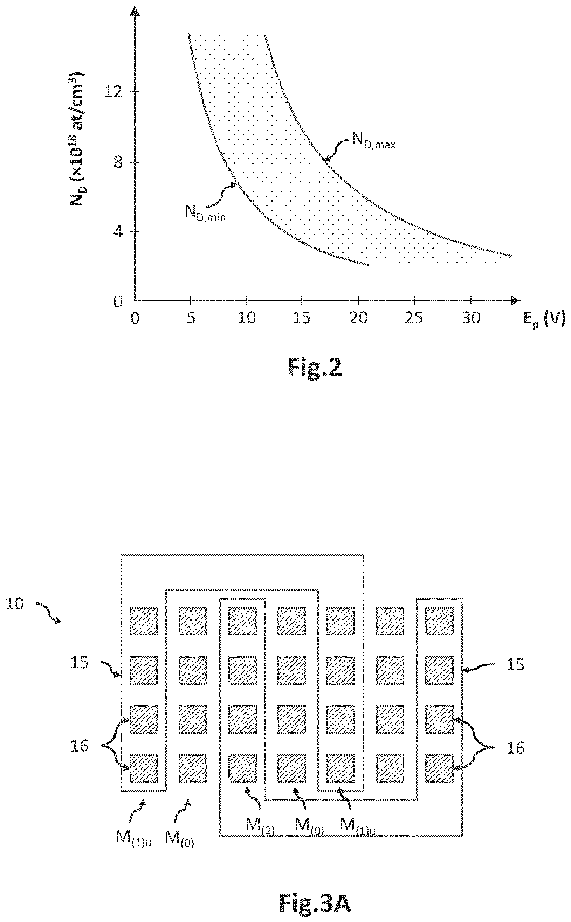

D'une manière générale, la réaction de porosification électrochimique est une réaction sélective dans le sens où, pour une même tension électrique Eₚ appliquée, un matériau semiconducteur cristallin dopé à base de GaN sera porosifié si son niveau de dopage N_{D} est supérieur ou égal à un niveau de dopage minimal N_{D,min} prédéfini. Dans le cas contraire, il ne sera pas porosifié et restera intègre (dense). A ce titre, la figure 2 illustre un exemple du domaine d'existence de la porosification électrochimique en fonction du niveau de dopage N_{D} (ici en donneurs) du matériau cristallin à base de GaN et de la tension électrique Eₚ appliquée, tel que décrit notamment dans le document EP3840016A1.

Le niveau de dopage minimal N_{D,min} dépend de la tension électrique Eₚ selon une fonction décroissante : plus la tension électrique Eₚ est élevée, moins le niveau de dopage minimal N_{D,min} requis pour porosifier le matériau cristallin est élevé. Autrement dit, pour une valeur prédéfinie de la tension électrique Eₚ appliquée lors de l'étape de porosification électrochimique, le matériau cristallin ayant un niveau de dopage N_{D} inférieur à la valeur minimale Nₘᵢₙ ne sera pas porosifié (rendu poreux) et restera donc intègre ou dense (non poreux) : ce matériau peut donc être qualifié de « non porosifiable ». En revanche, pour cette même valeur Eₚ, ce même matériau, lorsqu'il présente un niveau de dopage N_{D} au moins égal à la valeur minimale N_{D,min}, sera porosifié (rendu poreux) et peut donc être qualifié de « porosifiable ».

Aussi, les matériaux cristallins à base de GaN sont dits porosifiables ou non porosifiables, compte tenu d'une même valeur prédéfinie Eₚ de la tension électrique qui est appliquée lors de l'étape de porosification électrochimique, en fonction d'une même valeur minimale N_{D,min} prédéfinie du niveau de dopage. Dans le cadre de l'invention, les couches dopées 13, 15 sont réalisées en un matériau cristallin à base de GaN dit « porosifiable », alors que la couche inférieure d'isolation 12 et la couche intermédiaire d'isolation 14 sont réalisées en un matériau cristallin à base de GaN dit « non porosifiable ».

La porosification de toutes les N couches dopées des mésas M₍ᵢ₎, ou de seulement l'une d'entre elles, permet d'obtenir une relaxation plus ou moins importante au sein des mésas M₍ᵢ₎. Ainsi, une couche dopée porosifiée devient déformable, et autorisera une relaxation partielle ou totale de la ou des couches supérieure(s) non poreuse(s), qu'il s'agisse de la couche dopée supérieure 15 si elle est non poreuse et/ou de la couche de reprise d'épitaxie 16. Aussi, le substrat de croissance 10 peut présenter les caractéristiques suivantes :
- dans les mésas M_{(N)} où le niveau de porosification P_{(N)} est maximal, le fait que toutes les couches dopées 13, 15 soient devenues poreuses les rend donc déformables vis-à-vis des contraintes mécaniques générées par la couche de reprise d'épitaxie 16, de sorte que celle-ci se relaxe et présente un paramètre de maille effectif a^{e}_{cre(N)} pouvant alors être sensiblement égal à celui de son matériau massif a^{m}_{cre} : a^{e}_{cre(N)} ≈ a^{m}_{cre} ;
- dans les mésas M₍₀₎ où le niveau de porosification P₍₀₎ est minimal, comme aucune des couches dopées 13, 15 n'ait été rendue poreuse et donc déformable, la couche de reprise d'épitaxie 16 continue de subir les contraintes mécaniques générées par la couche inférieure d'isolation 12, et présente donc un paramètre de maille effectif a^{e}_{cre(0)} pouvant être sensiblement égal à celui de la couche inférieure d'isolation 12 : a^{e}_{cre(0)} ≈ a^{e}_{cii};
- dans les mésas M₍ₙ₎ où le niveau de porosification P₍ₙ₎ est intermédiaire, une couche dopée porosifiée sera donc rendue déformable et permettra à la couche supérieure non poreuse (la couche dopée 15 et/ou la couche de reprise d'épitaxie 16) de relaxer en partie :
   - si la couche poreuse est la couche dopée inférieure 13, et que la couche dopée supérieure 15 est non poreuse et est réalisée en AlGaN, celle-ci relaxe donc en partie grâce à la couche dopée 13 poreuse, la couche de reprise d'épitaxie 16 présentant alors un paramètre de maille effectif a^{e}_{cre(n)} qui pourra être inférieur à a^{e}_{cre(0)}. On pourra alors avoir un substrat de croissance 10 où : a^{e}_{cre(n)} < a^{e}_{cre(0)} < a^{e}_{cre(N)}.
   - si la couche poreuse est la couche dopée inférieure 13 et que la couche dopée supérieure 15 est non poreuse et est réalisée en InGaN, ou si la couche poreuse est la couche dopée supérieure 15, alors la couche de reprise d'épitaxie 16 présente un paramètre de maille effectif a^{e}_{cre(n)} qui pourra être supérieur à a^{e}_{cre(0)}. On pourra alors avoir un substrat de croissance 10 où : a^{e}_{cre(0)} < a^{e}_{cre(n)} < a^{e}_{cre(N)}.

Le substrat support 11 est réalisé ici en un matériau non porosifiable, de sorte qu'il reste non poreux (dense) lors de l'étape de porosification, à la tension électrique de polarisation prédéfinie. Il peut s'agir d'un matériau inerte à la réaction électrochimique de porosification, tel qu'un matériau isolant. Il peut s'agir d'un matériau semiconducteur à base de GaN dont le niveau de dopage est inférieur à la valeur minimale N_{D,min} de porosification (la valeur associée à la tension électrique de polarisation prédéfinie) : il peut alors être non intentionnellement dopé ou faiblement dopé. A titre d'exemple, le substrat support 11 peut être réalisé en saphir, en silicium, en SiC, en GaN autoportant (*freestanding* en anglais), entre autres. Il présente une épaisseur par exemple comprise entre 300µm et 1mm environ. Le substrat support 11 peut être absent, la couche inférieure d'isolation 12 étant alors une couche épaisse de plusieurs microns, de dizaines de microns, voire de centaines de microns.

La couche inférieure d'isolation 12 est réalisée en un matériau cristallin non porosifiable à base de GaN de sorte qu'il reste non poreux (dense) lors de l'étape de porosification, à la tension électrique de polarisation prédéfinie. Le matériau est ici de préférence du GaN dont le niveau de dopage est inférieur à la valeur minimale N_{D,min} prédéfinie. Il peut alors être non intentionnellement dopé ou faiblement dopé, par exemple présenter un niveau de dopage au plus égal à 5×10¹⁷ cm⁻³. Cette couche inférieure d'isolation 12, dans la mesure où elle est non porosifiable parce que non intentionnellement dopée ou faiblement dopée, présente une résistance électrique suffisante pour éviter que la couche dopée inférieure 13 des mésas M₍₀₎ et celle des M₍₁₎ᵤ ne soient porosifiées. Autrement dit, la couche dopée inférieure 13 des mésas M₍₀₎ et celle des mésas M₍₁₎ᵤ, qui ne sont pas au contact d'une électrode de polarisation, présentent un potentiel électrique suffisamment faible pour que la réaction électrochimique de polarisation n'ait pas lieu.

La couche inférieure d'isolation 12 présente ici une épaisseur par exemple comprise entre 100nm et 6µm environ. Elle a été réalisée par épitaxie à partir du substrat support 11 et repose ainsi sur et au contact de celui-ci (mais une couche intermédiaire peut être présente). Elle peut être continue ou non dans le plan XY. Par ailleurs, la couche inférieure d'isolation 12 présente un paramètre de maille dit effectif inférieur à celui de l'InₓGa₁₋ₓN massif de la couche de reprise d'épitaxie 16.

Chacune des couches dopées 13, 15 est réalisée en un matériau semiconducteur cristallin dopé, porosifiable, à base de GaN. Elles sont destinées à être rendues poreuses ou non lors de l'étape de porosification électrochimique, selon la catégorie de la mésa correspondante, de manière à obtenir le taux de relaxation voulu. Aussi, le matériau présente un niveau de dopage au moins égal à la valeur minimale N_{D,min} prédéfinie. Le matériau peut être choisi parmi l'InGaN, l'AlGaN, l'InAlGaN, et/ou le GaN. Dans cet exemple, elles sont toutes réalisées en InGaN (proportion d'indium non nulle). Selon une variante présentée plus loin, la couche dopée supérieure 15 est réalisée en AlGaN alors que la couche dopée inférieure 13 est réalisée en InGaN.

Par ailleurs, les couches dopées 13, 15 présentent de préférence le même type de conductivité, ici un dopage de type n, mais elles peuvent être dopées de type p. Elles présentent une épaisseur par exemple comprise entre 50nm et 1µm environ, ici égale à 800nm environ. Les couches dopées 13, 15 d'une même mésa M₍ᵢ₎ peuvent présenter une même épaisseur ou une épaisseur différente d'une couche dopée à l'autre.

Chaque mésa M₍ᵢ₎ comporte au moins une couche intermédiaire d'isolation 14, qui sépare les couches dopées 13, 15 deux à deux, suivant l'axe Z. Elle permet de réaliser les mésas M₍₁₎ en assurant, lors de la porosification de l'une des couches dopées (par exemple la couche dopée 15 dans la mésa M₍₁₎ᵤ), une isolation de l'autre couche dopée adjacente de sorte qu'elle ne soit pas porosifiée (ici la couche dopée 13 dans la mésa M₍₁₎ᵤ). La couche intermédiaire d'isolation 14 est réalisée en un matériau semiconducteur cristallin, non porosifiable, à base de GaN. Aussi, le matériau reste non poreux (dense) lors de l'étape de porosification électrochimique. Le matériau peut être choisi parmi l'InGaN, l'AlGaN, l'InAlGaN, et/ou le GaN, et présente un niveau de dopage inférieur à la valeur minimale N_{D,min} prédéfinie. Il peut ainsi être non intentionnellement dopé ou faiblement dopé, par exemple présenter un niveau de dopage au plus égal à 5×10¹⁷ cm⁻³.

Cette couche intermédiaire d'isolation 14, dans la mesure où elle est non porosifiable parce que non intentionnellement dopée ou faiblement dopée (et de préférence non intentionnellement dopé), présente une résistance électrique suffisante pour éviter que les couches dopées inférieures 13 des mésas M₍₁₎ᵤ, ainsi que les couches dopées supérieures 15 des mésas M_{(1)d}, ne sont pas porosifiées. Autrement dit, en ce qui concerne par exemple les mésas M₍₁₎ᵤ, les couches dopées inférieures 13, qui ne sont pas au contact d'une électrode de polarisation, présentent un potentiel électrique suffisamment faible du fait de la présence de la couche intermédiaire d'isolation 14, pour que la réaction électrochimique de polarisation n'ait pas lieu.

La couche intermédiaire d'isolation 14 est réalisée par épitaxie à partir de la couche dopée sous-jacente. Elle est de préférence au contact des couches dopées 13, 15 adjacentes. Son épaisseur est choisie pour assurer d'une part une bonne isolation (résistance électrique suffisante) entre les deux couches dopées 13, 15 adjacentes lors de l'étape de porosification électrochimique, et d'autre part une bonne transmission des contraintes mécaniques suivant l'axe Z. Elle est inférieure à celles des couches dopées 13 ,15. Elle est de préférence comprise entre 10nm et 100nm, et de préférence entre 10nm et 50nm environ.

La couche de reprise d'épitaxie 16 est une couche du substrat de croissance 10 qui peut être réalisée avant l'étape de porosification électrochimique, c'est-à-dire lors de la fabrication du substrat de croissance 10, voire peut être réalisée après l'étape de porosification électrochimique, par exemple lors de la fabrication de la matrice de diodes D₍ᵢ₎. Elle est réalisée en un matériau cristallin à base d'InGaN qui peut être choisi parmi l'InGaN et l'InAlGaN, et est destinée à permettre la réalisation des diodes D₍ᵢ₎ par reprise d'épitaxie. Elle est réalisée ici par épitaxie à partir de la couche dopée supérieure 15.

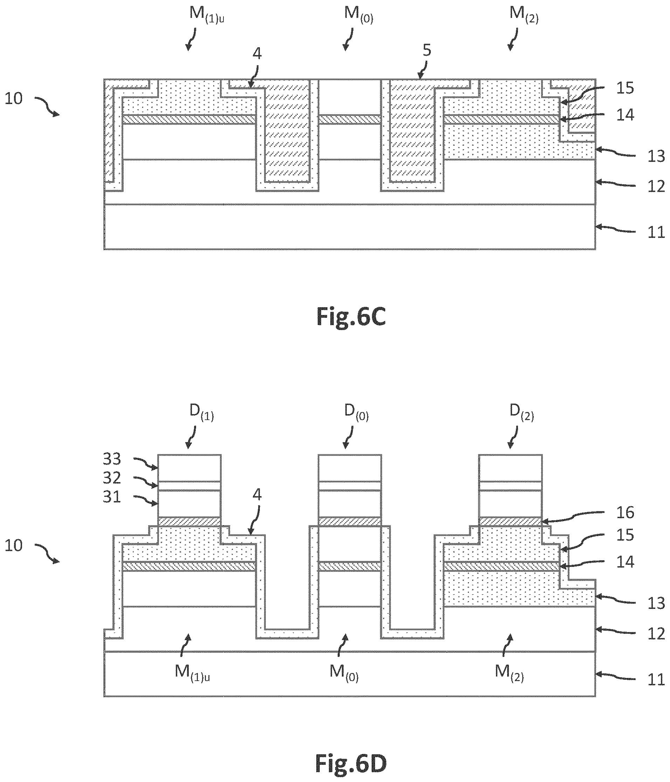

Dans le cas où la couche de reprise d'épitaxie 16 est réalisée avant l'étape de porosification électrochimique (dans le cadre du procédé de fabrication du substrat de croissance 10, cf. fig.5A-5H), elle est réalisée en un matériau non porosifiable. Aussi, le matériau reste non poreux (dense) lors de l'étape de porosification électrochimique. Le matériau présente alors un niveau de dopage inférieur à la valeur minimale N_{D,min} prédéfinie. Dans cet exemple, elle est réalisée en InₓGa₁₋ₓN non intentionnellement dopé ou faiblement dopé, avec une proportion d'indium x non nulle. En variante, dans le cas où la couche de reprise d'épitaxie 16 est réalisée après l'étape de porosification électrochimique, par exemple lors de la fabrication de la matrice de diodes D₍ᵢ₎ (cf. fig.6D), peu importe qu'elle soit réalisée en un matériau porosifiable ou non. Notons que dans ce dernier cas, la couche de reprise d'épitaxie peut être l'une des couches dopées formant la jonction semiconductrice d'une diode D₍ᵢ₎.

La couche de reprise d'épitaxie 16 présente une épaisseur et une proportion d'indium x non nulle telles qu'elle participe à obtenir les taux de relaxation souhaités R₍ᵢ₎ pour les mésas M₍₁₎ et M₍₂₎, comme expliqué en détail plus loin. A titre d'exemple, elle présente une épaisseur de 200nm environ et une proportion d'indium x au moins égale à 8%. Elle peut présenter une épaisseur moindre, par exemple de 100nm environ, et une proportion d'indium x plus élevée, par exemple d'au moins 12% environ.

Notons ici que les couches dopées 13, 15 et la couche intermédiaire d'isolation 14 (et de la couche de reprise d'épitaxie 16 le cas échéant) présentent chacune une épaisseur inférieure à son épaisseur critique à laquelle il y a une relaxation plastique des contraintes mécaniques. L'épaisseur totale de l'empilement de ces couches est également inférieure à une épaisseur critique prédéfinie, de manière à rester en contrainte pseudomorphique sur la couche inférieure d'isolation 12. Ainsi, la couche inférieure d'isolation 12 génère, dans les couches dopées 13, 14, 15, des contraintes mécaniques (orientées dans le plan XY) dont la valeur est telle que, avant porosification, le paramètre de maille au niveau de la face supérieure des mésas M₍ᵢ₎ est proche ou sensiblement égal au paramètre de maille effectif a^{e}_{cii} de la couche inférieure d'isolation 12.

Dans la mesure où les mésas M₍ᵢ₎ sont réalisées à partir du même empilement cristallin initial 20, chaque couche d'une mésa M₍ᵢ₎ est coplanaire avec les couches correspondantes des autres mésas. Ainsi, les couches de reprise d'épitaxie 16 sont coplanaires entre elles et définissent des faces supérieures également coplanaires. Les couches dopées inférieures 13 sont coplanaires entre elles. Il en est de même pour les couches intermédiaires d'isolation 14 d'une part, et pour les couches dopées supérieures 15 d'autre part.

De plus, chaque couche d'une mésa M₍ᵢ₎ présente une épaisseur identique à celle des couches correspondantes des autres mésas. Ainsi, les couches de reprise d'épitaxie 16 présentent une même épaisseur entre elles. Il en est de même pour les couches dopées inférieures 13, pour les couches intermédiaires 14, et enfin pour les couches dopées supérieures 15. Comme indiqué précédemment, les couches 14, 16 présentent une épaisseur inférieure à celles des couches dopées 13, 15.

Dans l'exemple de la fig.1B, le substrat de croissance 10 comporte une couche inférieure d'isolation 12 en GaN contraint par le substrat 11 en saphir (paramètre de maille ici de 3.184Â), et comporte, de bas en haut : une couche dopée inférieure 13 en InGaN, une couche intermédiaire d'isolation 14 en InGaN, et une couche dopée supérieure 15 en InGaN, et enfin une couche de reprise d'épitaxie 16 en InₓGa₁₋ₓN d'une épaisseur de 200nm environ et une proportion d'indium x égale à 8% environ. La mésa M₍₀₎ présente un taux de relaxation minimal R₍₀₎ de sorte que la couche de reprise d'épitaxie 16 présente un paramètre de maille proche ou sensiblement égal à celui (3.184Å) de la couche inférieure d'isolation 12. La mésa M_{(N)} présente un taux de relaxation maximale R_{(N)} de sorte que la couche de reprise d'épitaxie 16 présente un paramètre de maille proche ou sensiblement égal à celui de l'In_{0.08}Ga_{0.92}N massif (3.217Å environ), du fait de la déformation élastique des couches dopées 13 et 15 poreuses. La mésa M₍₁₎ᵤ présente un taux de relaxation intermédiaire R₍₁₎ᵤ de sorte que la couche de reprise d'épitaxie 16 présente un paramètre de maille compris entre 3.184Å et 3.217Å. On a donc a^{e}_{cre(0)} < a^{e}_{cre(1)u} < a^{e}_{cre(N)}. Ainsi, la matrice de diodes peut alors comporter des diodes D₍₀₎ émettant dans le bleu, des diodes D₍₁₎ᵤ émettant dans le vert, et des diodes D_{(N)} émettant dans le rouge.

Dans l'exemple de la fig.1C, le substrat de croissance 10 est identique à celui de la fig.1B, si ce n'est que la couche dopée supérieure 15 est réalisée en AlGaN. Les mésas M₍₀₎ et M_{(N)} présentent sensiblement les mêmes caractéristiques que dans la fig.1B. En revanche, en ce qui concerne la mésa M_{(1)d}, la porosification de la couche dopée 13 la rend déformable élastiquement, de sorte que les contraintes mécaniques de la couche dopée 15 en AlGaN peuvent alors déformer la couche dopée 13 poreuse, qui en retour va permettre à la couche dopée 15 de relaxer au moins partiellement et donc présenter un paramètre de maille inférieur à celui de la couche inférieure d'isolation 12. Aussi, la couche de reprise d'épitaxie 16, épitaxiée à partir de l'AlGaN de la couche dopée 15, présente un paramètre de maille inférieur à celui de la mésa M₍₀₎. On a donc a^{e}_{cre(1)d} < a^{e}_{cre(0)} < a^{e}_{cre(N)}. Ainsi, la matrice de diodes peut alors comporter des diodes D_{(1)d} émettant dans le bleu, des diodes D₍₀₎ émettant dans le vert, et des diodes D_{(N)} émettant dans le rouge.

Ainsi, le substrat de croissance 10 comporte des mésas de différentes catégories M₍ᵢ₎ présentant des niveaux de porosification P₍ᵢ₎ différents, autorisant des taux de relaxation R₍ᵢ₎ différents. Un tel substrat de croissance 10 permet alors de réaliser une matrice de diodes D₍ᵢ₎ adaptées à émettre ou à recevoir, de manière native, un rayonnement lumineux à différentes longueurs d'onde. Ce substrat de croissance 10 est obtenu à partir d'un empilement cristallin original 20 fait de N couches dopées 13, 15 séparées deux à deux par une couche intermédiaire d'isolation 14, dont certaines seulement des couches dopées sont rendues poreuses lors d'une même étape de porosification électrochimique, grâce à la présence de la couche intermédiaire d'isolation 14. Cette couche intermédiaire d'isolation 14, par le fait qu'elle est réalisée en un matériau non porosifiable (parce que non intentionnellement dopé ou faiblement dopé), permet, par sa résistance électrique, d'éviter que la réaction électrochimique de porosification n'ait lieu dans la couche dopée adjacente qu'on ne souhaite pas porosifier. On obtient ainsi les différentes catégories de mésas M₍ᵢ₎, sans qu'il soit nécessaire de réaliser des étapes d'implantation localisée de dopants comme dans le procédé de fabrication de l'art antérieur mentionné précédemment.

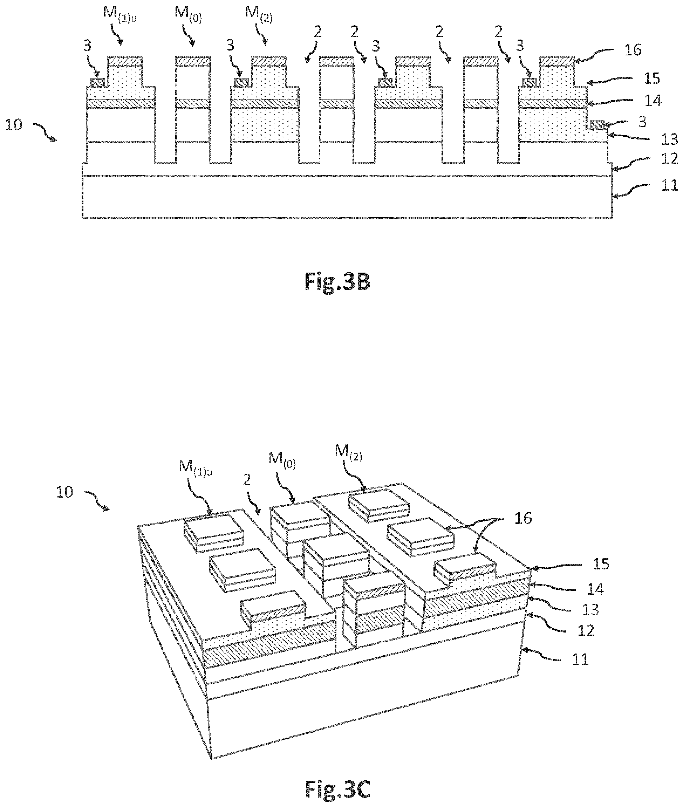

Les figures 3A à 3C illustrent, en vue de dessus (fig.3A), en coupe transversale (fig.3B), et en perspective (fig.3C), un substrat de croissance 10 similaire à celui de la fig.1B, qui comporte plusieurs mésas M₍₀₎, plusieurs mésas M₍₁₎ᵤ et plusieurs mésas M₍₂₎. Dans cet exemple, les mésas M₍₁₎ᵤ et les mésas M₍₂₎ sont séparées par les mésas M₍₀₎ suivant l'axe X. Les mésas M₍₀₎, M₍₁₎ᵤ et M₍₂₎ sont respectivement alignées suivant l'axe Y. D'autres agencements sont bien entendu possibles.

La couche dopée supérieure 15 des mésas M₍₁₎ᵤ est ici continue et s'étend continûment dans le plan XY pour relier entre eux tous les mésas M₍₁₎ᵤ du substrat de croissance 10. Autrement dit, chaque couche dopée poreuse 15 des mésas M₍₁₎ᵤ est une partie d'une même couche continue poreuse qui s'étend d'une mésa M₍₁₎ᵤ à l'autre. Il en est de même pour les couches dopées supérieure et inférieure des mésas M₍₂₎ qui s'étendent continûment dans le plan XY pour relier entre eux les mésas M₍₂₎ du substrat de croissance 10.

Les couches de reprise d'épitaxie 16 restent distinctes d'une mésa M₍₁₎ᵤ à l'autre dans le plan XY. Il en est de même pour les mésas M₍₂₎. Une tranchée 2 qui débouche sur la couche inférieure d'isolation 12 sépare les mésas M₍₀₎ vis-à-vis des mésas M₍₁₎ᵤ d'une part, et vis-à-vis des mésas M₍₂₎ d'autre part. Cette même tranchée 2 sépare les mésas M₍₀₎ les unes des autres dans le plan XY.

La couche dopée supérieure 15 des mésas M₍₁₎ᵤ et M₍₂₎ comporte une échancrure définissant ainsi une partie haute ayant sensiblement des dimensions identiques dans le plan XY que la couche de reprise d'épitaxie 16, et une partie basse ayant des dimensions plus importantes. L'échancrure peut être mise à profit pour qu'une électrode 3 y soit déposée, cette électrode 3 étant raccordée à un générateur électrique lors de l'étape de porosification électrochimique (par ex. à l'anode du générateur). Cette échancrure et l'électrode 3 peuvent être présentes au niveau de toutes les mésas M₍₁₎ᵤ et M₍₂₎, où seulement au niveau de ceux situés en bordure du substrat de croissance 10.

De plus, la couche dopée inférieure 13 des mésas M₍₂₎ comporte également une échancrure définissant ainsi une partie haute ayant sensiblement des dimensions identiques dans le plan XY que la partie basse de la couche dopée supérieure 15, et une partie basse ayant des dimensions plus importantes. L'échancrure est ici également mise à profit pour qu'une électrode 3 y soit déposée, cette électrode 3 étant raccordée au générateur électrique (ici, à l'anode également). Cette échancrure et l'électrode 3 peuvent être présentes au niveau de toutes les mésas M₍₂₎, où seulement au niveau de ceux situés en bordure du substrat de croissance 10.

Notons que ces échancrures peuvent être absentes, et l'anode du générateur peut être électriquement raccordée à une surface latérale de la couche dopée supérieure 15 des mésas M₍₁₎ᵤ et M₍₂₎ et à une surface latérale de la couche dopée inférieure 13 des mésas M₍₂₎.

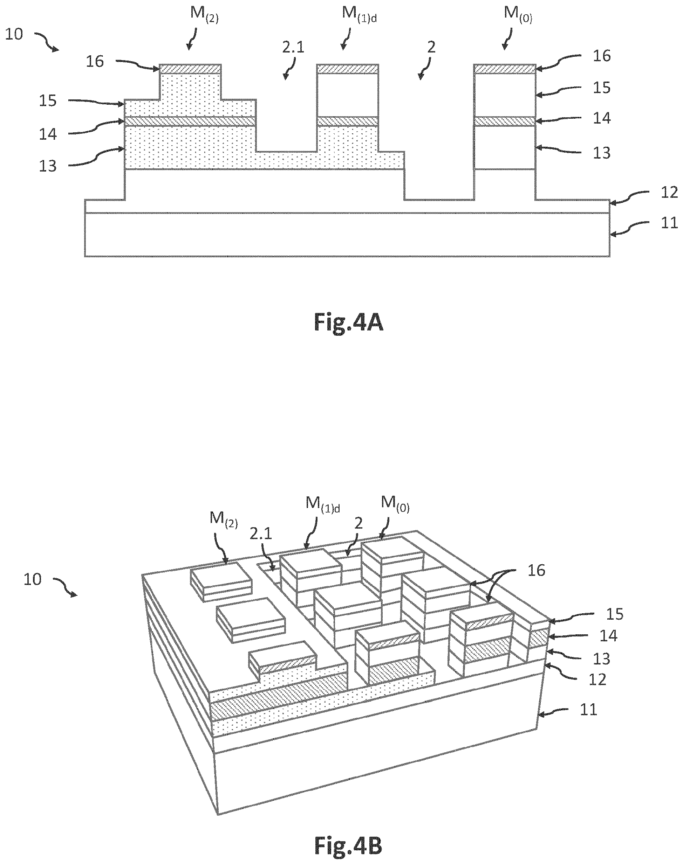

Les figures 4A et 4B sont des vues schématiques et partielles, en coupe transversale (fig.4A) et en perspective (fig.4B), d'un substrat de croissance 10 similaire à celui de la fig.1C, dans la mesure où il comporte plusieurs mésas M₍₀₎, plusieurs mésas M_{(1)d} et plusieurs mésas M₍₂₎..

Dans cet exemple, le substrat de croissance 10 est similaire à celui de la fig.3A, et s'en distingue essentiellement en ce que la couche dopée inférieure 13 poreuse des mésas M_{(1)d} est continue avec celle, poreuse également, des mésas M₍₂₎. Autrement dit, les mésas d'une catégorie M₍ₙ₎ comportent une couche dopée poreuse qui est une partie d'une même couche continue poreuse qui s'étend dans une mésa d'une catégorie M₍ₙ₊₁₎ différente.

Ainsi, alors qu'une tranchée 2 qui débouche sur la couche inférieure d'isolation 12 sépare les mésas M₍₀₎ vis-à-vis des mésas M_{(1)d} et M₍₂₎ dans le plan XY, une autre tranchée 2.1 moins profonde, débouchant sur la couche dopée inférieure 13, sépare les mésas M_{(1)d} des mésas M₍₂₎ dans le plan XY au niveau de leur couche dopée supérieure 15. Ainsi, la même couche dopée inférieure 13 des mésas M_{(1)d} et M₍₂₎ peut être au contact d'une même électrode 3 raccordée à l'anode du générateur électrique.

Les figures 5A à 5H illustrent différentes étapes d'un procédé de fabrication d'un substrat de croissance 10 similaire à celui de la fig.1B, puis du dispositif optoélectronique 1. Dans cet exemple, les diodes sont électroluminescentes, et le dispositif optoélectronique 1 est un micro-écran à émission native RGB.

En référence à la fig.5A, on fournit tout d'abord un empilement cristallin 20 comportant, sur un substrat support 11 qui s'étend dans le plan principal XY : une couche continue inférieure d'isolation 22, une couche continue dopée inférieure 23, une couche continue intermédiaire d'isolation 24, une couche continue dopée supérieure 25, et ici une couche continue de reprise d'épitaxie 26. Ces couches s'étendent dans le plan XY de manière continue sur toute l'étendue du substrat support 11. Les différentes couches sont obtenues par des étapes successives d'épitaxie à partir du substrat support 11.

La couche inférieure d'isolation est réalisée en un matériau cristallin non porosifiable à base de GaN, ici en GaN non intentionnellement dopé. La couche continue dopée inférieure 23 comme la couche continue dopée supérieure 25 sont réalisées en un matériau cristallin porosifiable à base de GaN, ici en InₓGa₁₋ₓN, avec une proportion d'indium x qui est de préférence comprise entre 0% et 15%. Dans cet exemple, la proportion d'indium x des couches 23 et 25 est non nulle. L'InGaN est dopé de type n entre 3×10⁸ cm⁻³ et 1.5×10⁹ cm⁻³, par exemple égale à 6×10⁸ cm⁻³ environ. L'épaisseur est ici comprise entre 50nm et 1µm, par exemple égale à 800nm environ. La couche continue intermédiaire d'isolation 24 et la couche continue de reprise d'épitaxie 26 sont réalisées en un matériau cristallin non porosifiable à base de GaN, ici en InGaN (dans cet exemple, la proportion d'indium x est non nulle) non intentionnellement dopé ou faiblement dopé.

En référence à la fig.5B, on réalise ici une gravure localisée de la couche continue de reprise d'épitaxie 26 pour former des plots de nucléation (formant les couches de reprise d'épitaxie 16), distincts les uns des autres dans le plan XY, destinés à la réalisation des diodes D₍ᵢ₎, et déboucher dans la couche continue dopée supérieure 25 (formant ici une partie haute et une partie basse continue). La gravure peut notamment être réalisée par un procédé de type plasma ICP-RIE en gaz chloré. Cette première étape, facultative, permet de réaliser les couches de reprise d'épitaxie 16 des mésas M₍₀₎, M₍₁₎ et M₍₂₎, ainsi que des parties haute et basse de la couche continue dopée supérieure 25 des mésas M₍₁₎ et M₍₂₎.

En référence à la fig.5C, on réalise ensuite une gravure localisée de la couche continue dopée supérieure 25, de la couche continue intermédiaire 24, et de la couche continue dopée inférieure 23, pour déboucher dans la couche continue inférieure 22. On forme ainsi une ou des tranchées 2 permettant d'isoler dans le plan XY les mésas M₍₀₎ les uns des autres et vis-à-vis des mésas M₍₁₎ et M₍₂₎, et d'isoler les mésas M₍₁₎ vis-à-vis des mésas M₍₂₎.

Les mésas M₍₁₎ comportent ici une couche dopée supérieure 15, destinée à être rendue poreuse, commune d'une mésa à l'autre, et sont également reliées les uns aux autres par cette même couche dopée supérieure 15 (comme sur la fig.3A). De même, les mésas M₍₂₎ comportent ici des couches dopées supérieure 15 et inférieure 13, destinées à être rendues poreuses, communes d'une mésa à l'autre, et sont reliés les unes aux autres par ces mêmes couches dopées supérieure 15 et inférieure 13.

Dans cet exemple, on dépose ensuite une électrode 3 sur et au contact de la couche dopée supérieure 15 des mésas M₍₁₎. Cette électrode 3 peut s'étendre sur toutes les mésas M₍₁₎, ou sur seulement les mésas M₍₁₎ situées en bordure du substrat de croissance 10. On réalise également une électrode 3 sur et au contact de la couche dopée supérieure 15 des mésas M₍₂₎, et une autre électrode 3 sur et au contact de la couche dopée inférieure 13 des mésas M₍₂₎. Ces électrodes 3 peuvent être situées de différentes manières, comme pour l'électrode 3 des mésas M₍₁₎.

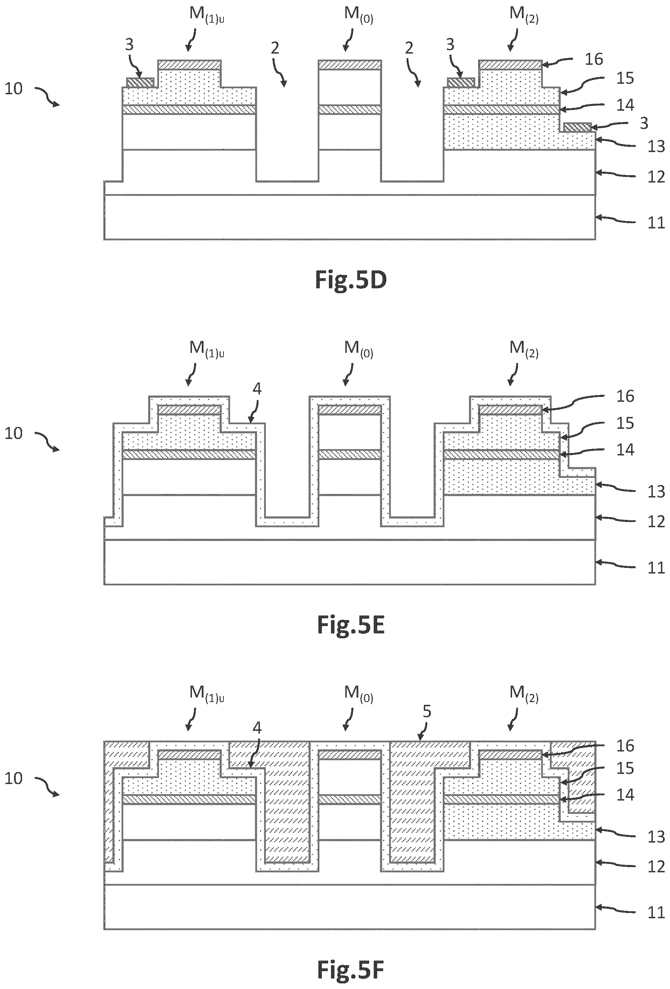

En référence à la fig.5D, on réalise ensuite une porosification électrochimique de la couche dopée supérieure 15 des mésas M₍₁₎ᵤ, et des couches dopées supérieure 15 et inférieure 13 des mésas M₍₂₎, de manière simultanée. Les couches dopées supérieure 15 et inférieure 13 des mésas M₍₀₎ ne sont pas rendues poreuses lors de cette étape car elles ne sont pas connectées électriquement au générateur électrique. De plus, la couche dopée inférieure 13 des mésas M₍₁₎ᵤ n'est pas rendue poreuse car la couche intermédiaire d'isolation 14, par sa résistance électrique, empêche que la réaction électrochimique de porosification ait lieu dans cette couche dopée inférieure 13 (qu'on ne souhaite pas porosifier).

Pour cela, on plonge le substrat de croissance 10 dans un électrolyte liquide, les couches dopées à rendre poreuses étant connectées ici à l'anode du générateur électrique. Le substrat de croissance 10 forme ainsi une électrode de travail. Une contre-électrode, ici une grille en platine de surface déployée importante et en regard de la surface de l'électrode de travail, est plongée dans l'électrolyte, et est raccordée à la cathode du générateur électrique. Le générateur électrique applique une tension électrique Eₚ dont la valeur a été prédéterminée, ce qui conduit à porosifier des couches concernées, et donc à une relaxation différente des différentes mésas. Plus précisément, les mésas M₍₀₎ n'ont aucune couche rendue poreuse et présentent le taux de relaxation R₍₀₎ qui reste identique avant et après l'étape de porosification électrochimique ; les mésas M₍₂₎ ont leurs couches dopées supérieure 15 et inférieure 13 qui sont rendues poreuses, ce qui conduit à un taux de relaxation R₍₂₎ maximal, relaxant ici de manière totale les couches de reprise d'épitaxie 16 ; et les mésas M₍₁₎ ont leur couche dopée supérieure 15 seulement qui est rendue poreuse, ce qui conduit à un taux de relaxation R₍₁₎ compris entre et différent de R₍₀₎ et R₍₂₎.

L'électrolyte liquide peut être acide ou basique, et peut être de l'acide oxalique. Il peut également s'agir de KOH, HF, HNO₃, NaNO₃, H₂SO₄ ou de leur mélange. On peut ainsi utiliser également un mélange d'acide oxalique et de NaNO₃. La tension électrique appliquée entre l'anode et la cathode peut être par exemple comprise entre 1V et 100V. Elle peut être appliquée pendant une durée allant de quelques secondes à quelques heures. Lorsqu'il n'y a plus de courant, la réaction électrochimique s'arrête et la porosification des couches dopées correspondantes est réalisée.

On obtient ainsi un substrat de croissance 10, comportant des mésas M₍ᵢ₎ présentant différents taux de relaxation R₍ᵢ₎, et formés à partir d'un même empilement cristallin 20 original. Cette relaxation des contraintes mécaniques différenciée d'une catégorie de mésas à l'autre est obtenue lors d'une même étape de porosification électrochimique, sans qu'il ait été nécessaire de réaliser des niveaux de dopage différents d'une catégorie de mésa M₍ᵢ₎ à l'autre. Ces mésas M₍ᵢ₎ présentent toutes une couche de reprise d'épitaxie 16 en InₓGa₁₋ₓN avec la même proportion d'indium x, mais avec une relaxation différente selon que l'on considère les différentes catégories. Ils sont donc adaptés à la réalisation par épitaxie d'une matrice de diodes D₍ᵢ₎ permettant d'émettre ou de recevoir un rayonnement lumineux à différentes longueurs d'onde.

En référence aux fig.5E à 5H, on fabrique ensuite la matrice de diodes D₍ᵢ₎, par reprise d'épitaxie à partir des mésas du substrat de croissance 10. Dans cet exemple, les diodes sont électroluminescentes. On réalise ici des diodes D₍₀₎ à partir des mésas M₍₀₎, des diodes D₍₁₎ à partir des mésas M₍₁₎, et des diodes D₍₂₎ à partir des mésas M₍₂₎.

En référence à la fig.5E à 5G, après avoir retiré les électrodes 3 par exemple par gravure chimique sélective, on réalise tout d'abord un masque de croissance 4 sur le substrat de croissance 10, de manière à le recouvrir entièrement sauf au niveau des surfaces supérieures des couches de reprise d'épitaxie 16.

On dépose tout d'abord (cf. fig.5E), de manière conforme, une couche mince continue 4 en un matériau électriquement isolant tel qu'un nitrure de silicium, par exemple une couche mince de 80nm de SiN déposé par dépôt chimique en phase vapeur assisté par plasma (PECVD). Cette couche mince isolante 4 recouvre ainsi entièrement les mésas M₍ᵢ₎ ainsi que la surface libre, située entre les mésas M₍ᵢ₎, de la couche inférieure d'isolation 12, et présente une épaisseur sensiblement constante.

On dépose ensuite (cf. fig.5F) une couche épaisse de remplissage 5, par exemple en un polymère tel qu'une résine de lithographie, sur la couche mince isolante 4 de manière à recouvrir les mésas M₍ᵢ₎. On amincit ensuite cette couche épaisse 5, par exemple par gravure sèche sous plasma O₂, jusqu'à rendre libre la surface supérieure de la couche mince isolante 4 située au-dessus des couches de reprise d'épitaxie 16.

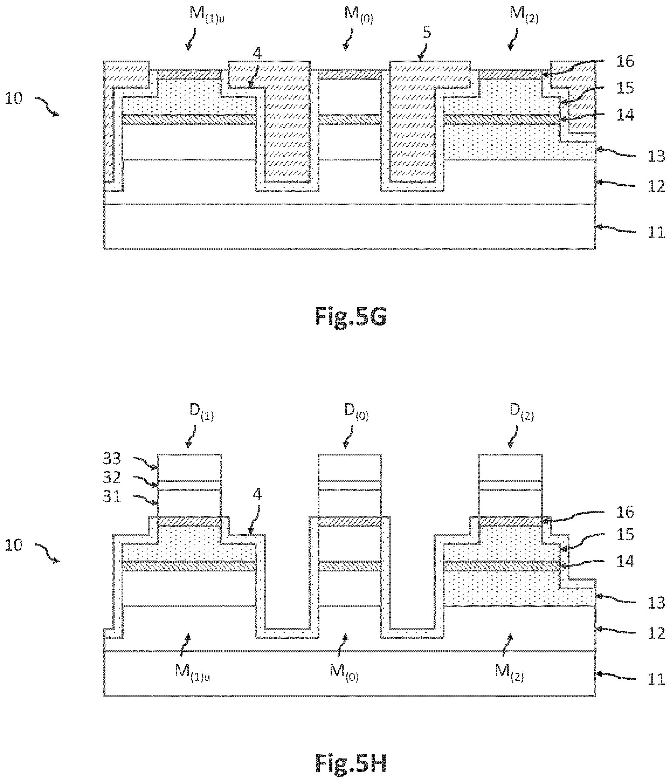

Enfin, on réalise (cf. fig.5G) des ouvertures débouchant sur la surface supérieure des couches de reprise d'épitaxie 16. Pour cela, on grave de manière sélective les parties rendues libres de la couche mince isolante 4, par exemple par gravure sous plasma fluoré. La couche épaisse 5 peut ensuite être supprimée par exemple par dissolution dans un solvant (comme illustré sur la fig.5H). On a ainsi réalisé un masque de croissance (la couche mince isolante 4), qui recouvre la surface des mésas M₍ᵢ₎ et la surface de la couche inférieure d'isolation 12 située entre les mésas, hormis la surface supérieure des couches de reprise d'épitaxie 16. Il s'agit d'un procédé auto-aligné où il n'y a pas eu recours à une étape de photolithographie. D'autres procédés peuvent toutefois être utilisés.

En référence à la fig.5H, on réalise les diodes D₍ᵢ₎ de manière simultanée, par reprise d'épitaxie à partir de couches de reprise d'épitaxie 16 des différentes mésas M₍ᵢ₎. On forme ainsi :
- des diodes D₍₀₎, à partir des mésas M₍₀₎, adaptées à émettre à une longueur d'onde principale λ₀, par exemple une lumière bleue dont la longueur d'onde λ₀ est par exemple comprise entre 440nm et 490nm environ ;
- des diodes D₍₁₎, à partir des mésas M₍₁₎, adaptées à émettre à une longueur d'onde principale λ₁, par exemple une lumière verte dont la longueur d'onde λ₁ est par exemple comprise entre 495nm et 560nm environ ; et
- des diodes D₍₂₎, à partir des mésas M₍₂₎, adaptées à émettre à une longueur d'onde principale λ₂, par exemple une lumière rouge dont la longueur d'onde λ₂ est par exemple comprise entre 600nm et 650nm environ.

Ceci est possible par le fait que les couches de reprise d'épitaxie 16 des mésas M₍₀₎, M₍₁₎ et M₍₂₎ présentent un paramètre de maille effectif différent d'une catégorie de mésas à l'autre, du fait des taux de relaxation différents R₍₀₎, R₍₁₎ et R₍₂₎. Aussi, l'incorporation d'indium dans les diodes, et en particulier dans les puits quantiques des couches actives, dépend en effet du paramètre de maille effectif (et donc du taux de relaxation) des couches de reprise d'épitaxie 16 des différentes mésas. Plus le paramètre de maille effectif d'une couche de reprise d'épitaxie 16 est important, plus la longueur d'onde principale de la diode correspondante sera grande.

Dans cet exemple, la couche de reprise d'épitaxie 16 des mésas M₍₀₎ présentent le taux de relaxation R₍₀₎ le plus faible, de sorte qu'elle présente un paramètre de maille effectif proche de celui de la couche inférieure d'isolation 12 en GaN, ce qui conduit à ce que les diodes D₍₀₎ émettent ici dans le bleu. A l'opposé, la couche de reprise d'épitaxie 16 des mésas M₍₂₎ présente le taux de relaxation R₍₂₎ le plus élevé, de sorte qu'elle présente un paramètre de maille effectif proche de celui de l'InₓGa₁₋ₓN massif (la proportion d'indium peut alors être comprise entre 10% et 20%, par exemple égale à 15%), conduisant ainsi à ce que les diodes D₍₂₎ émettent dans le rouge. Entre ces deux situations, la couche de reprise d'épitaxie 16 des mésas M₍₁₎ présente le taux de relaxation R₍₁₎ intermédiaire entre et différent de R₍₀₎ et R₍₂₎, de sorte que les diodes D₍₁₎ peuvent alors émettre dans le vert.

Les diodes D₍ᵢ₎ comportent *a minima* deux couches dopées 31, 33, l'une de type n et l'autre de type p, et une couche active intercalaire 32 comportant des puits quantiques. Les couches dopées 31, 33 et la couche active 32 peuvent être des multicouches (ainsi les puits quantiques sont classiquement situés entre des sous-couches barrières) et comporter d'autres couches ou sous-couches telles qu'une couche de blocage d'électrons.

A titre d'exemple, pour obtenir des diodes D₍₂₎ émettant dans le rouge, des diodes D₍₁₎ émettant dans le vert, et des diodes D₍₀₎ émettant dans le bleu, chaque diode D₍ᵢ₎ peut présenter l'empilement suivant (épitaxié à partir de la couche de reprise d'épitaxie 16), de bas en haut :
- une couche épaisse (ou couche substrat) réalisée en InGaN, avec une proportion d'indium comprise entre 10% et 20% environ, par exemple égale à 15%, dopée de type n, et d'une épaisseur comprise entre 50nm et 200nm ;
- un multicouche à base d'InGaN dopé de type n d'une épaisseur de 350nm environ, formé d'une alternance de 15 paires d'une sous-couche de 22nm d'In_{0.15}Ga_{0.85}N et d'une sous-couche de 1.8nm de GaN, voire une couche tampon de 400 à 500nm d'In_{0.15}Ga_{0.85}N dopé n ;
- une couche active comportant des puits quantiques multiples formés de 5 paires d'In_{0.40}Ga_{0.60}N / In_{0.15}Ga_{0.85}N d'épaisseurs 2-3nm et 5-8nm ;
- une couche d'espacement de 10nm d'In_{0.03}Ga_{0.97}N non intentionnellement dopé ;
- une couche de 20nm d'AIN ou de GaN dopé Mg ;
- une couche de 125nm d'InGaN dopé Mg avec une proportion d'indium comprise entre 10 et 15% environ ;
- une couche de 25n d'InGaN surdopé de type p avec la même proportion d'indium comprise entre 10 et 15% que la couche sous-jacente.

Par ailleurs, le procédé de fabrication du dispositif optoélectronique 1 comporte également une étape de réalisation d'électrodes de polarisation des diodes D₍ᵢ₎. Cette étape est classique et n'est pas décrite ici.

On obtient ainsi un dispositif optoélectronique 1 dont les diodes D₍ᵢ₎ sont adaptées ici à émettre de manière native à des longueurs d'onde différentes, ici dans les trois couleurs RGB, ceci grâce au substrat de croissance 10 qui a été réalisé à partir d'une seule étape de porosification électrochimique sans avoir eu recours à plusieurs étapes d'implantation localisée de dopants, et qui a permis de réaliser les diodes D₍ᵢ₎ à partir d'une seule étape de reprise d'épitaxie.

Les figures 6A à 6D illustrent des étapes d'un procédé de fabrication d'un substrat de croissance 10 puis de la matrice de diodes D₍ᵢ₎. Ce procédé se distingue de celui des fig.5A à 5H essentiellement en ce que la couche de reprise d'épitaxie 16 des mésas M₍ᵢ₎ est réalisée lors de la fabrication des diodes D₍ᵢ₎ donc après l'étape de porosification électrochimique.

En référence à la fig.6A, on réalise tout d'abord l'empilement cristallin 10. Les couches continues 22, 23, 24 et 25 sont identiques à celles de la fig.5A. Cependant, il ne comporte pas la couche continue de reprise d'épitaxie 26.

En référence à la fig.6B, on réalise ensuite les mésas M₍ᵢ₎ par gravure localisée de l'empilement cristallin 10, et on porosifie les couches dopées voulues. On obtient ainsi les mésas M₍₀₎, M₍₁₎ᵤ et M₍₂₎. Notons ici que les couches poreuses sont devenues déformables élastiquement. Elles permettront la relaxation des couches de reprise d'épitaxie 16 qui seront réalisées ensuite (et donc des mésas M₍ᵢ₎).

En référence à la fig.6C, on retire les électrodes 3, puis on dépose la couche mince isolante 4 puis la couche épaisse de remplissage 5. On amincit ensuite cette couche épaisse 5 jusqu'à rendre libre la surface supérieure de la couche mince isolante 4 située au-dessus de la face supérieure des couches dopées 15 des mésas M₍ᵢ₎.

En référence à la fig.6D, on réalise des ouvertures de manière à rendre libre la face supérieure des couches dopées 15 des mésas M₍ᵢ₎. La couche épaisse 5 peut ensuite être supprimée. On a ainsi fabriqué le substrat de croissance 10. Ici, la couche de reprise d'épitaxie 16 n'est pas encore déposée sur chacune des mésas M₍ᵢ₎.

Enfin, on réalise les différentes diodes D₍ᵢ₎ de manière simultanée. Pour cela, on peut réaliser par épitaxie une couche mince à base de GaN, et de préférence en InGaN avec une proportion d'indium de 1% environ, d'une épaisseur comprise entre 10 et 100nm environ. Cette couche mince est réalisée sur et au contact des couches dopées 15 des mésas M₍ᵢ₎, et permet d'obturer les pores débouchant au niveau de la face supérieure des couches dopées 15 poreuses. Ensuite, on peut réaliser par épitaxie la couche de reprise d'épitaxie 16 au niveau de chaque mésa M₍ᵢ₎. Cette couche 16 peut présenter une épaisseur de 200nm environ et une proportion d'indium de l'ordre de 8% environ. Elle provoque alors la déformation des couches poreuses des mésas M₍₁₎ et M₍₂₎, qui en retour permet à la couche 16 de relaxer. Les couches 31, 32, 33 des diodes sont ensuite réalisées. Notons ici que la couche 31 peut alors faire office de couche de reprise d'épitaxie.

Des modes de réalisation particuliers viennent d'être décrits. La portée de l'invention est définie par les revendications.

## Revendications

1. Substrat de croissance (10), adapté à la réalisation par épitaxie d'une matrice de diodes à base d'InGaN, comportant :
∘ une couche inférieure d'isolation (12) réalisée en un matériau cristallin non poreux à base de GaN ;
∘ des mésas M₍ᵢ₎, avec i allant de 0 à N, réalisées en des matériaux cristallins à base de GaN, reposant sur et au contact de la couche inférieure d'isolation (12), et comportant chacune N couches dopées (13, 15), avec N≥2, séparées deux à deux par une couche intermédiaire d'isolation (14) réalisée en un matériau non poreux, et présentant chacune une face supérieure libre adaptée à la réalisation par épitaxie d'une diode de la matrice ; les mésas étant configurées selon au moins trois catégories différentes parmi lesquels :
• une catégorie de mésas dite M_{(N)} où les N couches dopées (13, 15) sont poreuses ;
• une catégorie de mésas dite M₍₀₎ où aucune des couches dopées (13, 15) n'est poreuse ;
• une catégorie de mésas dite M₍ₙ₎ où n couches dopées (13, 15) sont poreuses, avec 1≤n<N.

2. Substrat de croissance (10) selon la revendication 1, dans lequel chaque mésa M₍ᵢ₎ comporte une couche de reprise d'épitaxie (16) reposant sur une couche dopée supérieure (15) parmi les N couches dopées (13, 15), réalisée en un matériau cristallin non poreux à base d'InGaN dont le paramètre de maille a^{m}_{cre} du matériau relaxé est supérieur au paramètre de maille effectif a^{e}_{cii} de la couche inférieure d'isolation (12) :
∘ la couche de reprise d'épitaxie (16) de chaque mésa M_{(N)} présentant un paramètre de maille maximal a^{e}_{cre(N)} ;
∘ la couche de reprise d'épitaxie (16) de chaque mésa M₍₀₎ présentant un paramètre de maille a^{e}_{cre(0)} inférieur à a^{e}_{cre(N)};
∘ la couche de reprise d'épitaxie (16) de chaque mésa M₍ₙ₎ présentant un paramètre de maille intermédiaire a^{e}_{cre(n)} inférieur à a^{e}_{cre(N)} et différent de a^{e}_{cre(0)}.

3. Substrat de croissance (10) selon la revendication 1 ou 2, dans lequel la couche intermédiaire d'isolation (14) de chaque mésa présente une épaisseur inférieure à celle des couches dopées (13, 15) adjacentes.

4. Substrat de croissance (10) selon la revendication 3, dans lequel la couche intermédiaire d'isolation (14) de chaque mésa présente une épaisseur comprise entre 10nm et 100nm.

5. Substrat de croissance (10) selon l'une quelconque des revendications 1 à 4, dans lequel la couche inférieure d'isolation (12) et la couche intermédiaire d'isolation (14) présente un niveau de dopage au plus égal à 5x10¹⁷ cm⁻³.

6. Substrat de croissance (10) selon l'une quelconque des revendications 1 à 5, dans lequel les couches dopées (13, 15) sont dopées de type n.

7. Substrat de croissance (10) selon l'une quelconque des revendications 1 à 6, dans lequel les couches dopées inférieures (13) des mésas M₍ᵢ₎ sont réalisées en le même matériau et présentent la même épaisseur d'une mésa à l'autre ; les couches intermédiaires d'isolation (14) des mésas M₍ᵢ₎ sont réalisées en le même matériau et présentent la même épaisseur d'une mésa à l'autre ; et les couches dopées supérieures (15) des mésas M₍ᵢ₎ sont réalisées en le même matériau et présentent la même épaisseur d'une mésa à l'autre.

8. Dispositif optoélectronique (1) comportant : un substrat de croissance (10) selon l'une quelconque des revendications précédentes ; et une matrice de diodes D(i) à base d'InGaN, épitaxiées à partir des mésas du substrat de croissance (10), les diodes étant adaptées à émettre ou à détecter un rayonnement lumineux à différentes longueurs d'onde, la longueur d'onde étant différente d'une catégorie de mésas M₍ᵢ₎ à l'autre.

9. Dispositif optoélectronique 1 selon la revendication 8, formant un micro-écran RGB où les diodes D₍ᵢ₎ sont des diodes électroluminescentes configurées pour émettre un rayonnement lumineux au moins dans le bleu et le rouge.

10. Procédé de fabrication d'un substrat de croissance (10) selon l'une quelconque des revendications 1 à 7, comportant les étapes suivantes :
∘ détermination d'une valeur d'une tension électrique à appliquer lors d'une étape ultérieure de porosification électrochimique ;
∘ réalisation d'un empilement cristallin (20), comportant, de bas en haut : une couche continue inférieure d'isolation (22) réalisée en un matériau cristallin à base de GaN et non porosifiable à ladite valeur prédéterminée de la tension électrique à appliquer ; N couches continues dopées (23, 25), avec N≥2, réalisées en des matériaux cristallins à base de GaN et porosifiables à ladite valeur prédéterminée de la tension électrique à appliquer ; au moins une couche continue intermédiaire d'isolation (24), séparant les couches continues dopées (23, 25) deux à deux, réalisée en un matériau cristallin à base de GaN et non porosifiable à ladite valeur prédéterminée de la tension électrique à appliquer ;
∘ gravure localisée de l'empilement cristallin (20), de manière à former lesdites mésas M₍ᵢ₎;
∘ réalisation de plusieurs électrodes (3), au contact des couches dopées à porosifier (13, 15) selon les différentes catégories de mésas M₍ᵢ₎;
∘ porosification électrochimique simultanée desdites couches dopées à porosifier (13, 15), par application aux couches dopées à porosifier (13, 15) de la valeur prédéterminée de la tension électrique.

11. Procédé de fabrication selon la revendication 10, dans lequel le matériau de la couche continue inférieure d'isolation (22) et le matériau de la couche continue intermédiaire d'isolation (24) présente un niveau de dopage inférieur à une valeur minimale prédéfinie à partir de laquelle ils peuvent être porosifiés compte tenu de la valeur prédéterminée de la tension électrique appliquée lors de l'étape de porosification.

12. Procédé de fabrication selon la revendication 10 ou 11, comportant les étapes suivantes :
∘ à la suite de l'étape de porosification, retrait des électrodes (3), puis dépôt conforme d'une couche mince isolante (4) recouvrant les mésas ;
∘ dépôt d'une couche épaisse de remplissage (5), remplissant les espaces entre les mésas, et amincissement de la couche épaisse de remplissage (5) de manière à rendre libre une portion supérieure de la couche mince isolante (4) recouvrant une surface supérieure des mésas M₍ᵢ₎ ;
∘ gravure sélective de la portion supérieure de la couche mince isolante (5), de manière sélective aux mésas M₍ᵢ₎, rendant libre la surface supérieure de celles-ci.

13. Procédé de fabrication selon l'une quelconque des revendications 10 à 12, dans lequel l'empilement cristallin (20) comprend une couche continue de reprise d'épitaxie (26) à base d'InGaN, reposant sur une couche continue dopée supérieure (25) parmi les N couches continues dopées (23, 25).

14. Procédé de fabrication selon l'une quelconque des revendications 10 à 12, dans lequel, après l'étape de porosification, une couche de reprise d'épitaxie (16) à base d'InGaN est réalisée sur une couche dopée supérieure (15) parmi les N couches dopées (13, 15) de chaque mésa M₍ᵢ₎.

15. Procédé de fabrication d'un dispositif optoélectronique selon l'une quelconque des revendications 8 et 9, comportant les étapes suivantes :
∘ fabrication du substrat de croissance par le procédé selon l'une quelconque des revendications 10 à 14 ; puis
∘ réalisation d'une matrice de diodes D₍ᵢ₎ par épitaxie à partir des mésas M₍ᵢ₎ du substrat de croissance (10), les diodes étant alors adaptées à émettre ou à détecter un rayonnement lumineux à différentes longueurs d'onde, la longueur d'onde étant différente d'une catégorie de mésas M₍ᵢ₎ à l'autre.

## Patentansprüche

1. Wachstumssubstrat (10), geeignet für die Herstellung einer Diodenmatrix auf InGaN-Basis durch Epitaxie, umfassend:
∘ eine untere Isolierschicht (12) aus einem nicht porösen kristallinen Material auf GaN-Basis;
∘ Mesas M₍ᵢ₎, wobei i von 0 bis N reicht, die aus kristallinen Materialien auf GaN-Basis hergestellt sind, auf der unteren Isolierschicht (12) ruhen und mit dieser in Kontakt stehen und jeweils N dotierte Schichten (13, 15) mit N≥2 umfassen, die paarweise durch eine isolierende Isolierzwischenschicht (14) getrennt sind, die aus einem nicht porösen Material hergestellt ist, und jeweils eine freie Oberseite aufweisen, die für die Herstellung einer Diode der Matrix durch Epitaxie geeignet ist; wobei die Mesas nach mindestens drei verschiedenen Kategorien eingerichtet sind, darunter:
• eine Mesaskategorie M_{(N)}, wobei die N dotierten Schichten (13, 15) porös sind;
• eine Mesaskategorie M₍₀₎, in der keine der dotierten Schichten (13, 15) porös ist;
• eine Mesaskategorie M₍ₙ₎, wobei n dotierte Schichten (13, 15) porös sind, mit 1≤n<N.

2. Wachstumssubstrat (10) nach Anspruch 1, wobei jede Mesa M₍ᵢ₎ eine Epitaxie-Aufnahmeschicht (16) umfasst, die auf einer oberen dotierten Schicht (15) der N dotierten Schichten (13, 15) ruht, die aus einem nicht porösen kristallinen Material auf InGaN-Basis hergestellt ist, dessen Maschenparameter a^{m}_{cre} des entspannten Materials größer ist als der effektive Maschenparameter a^{e}_{cii} der unteren Isolierschicht (12):
∘ wobei die Epitaxie-Aufnahmeschicht (16) jeder Mesa M_{(N)} einen maximalen Maschenparameter a^{e}_{cre(N)} aufweist;
∘ wobei die Epitaxie-Aufnahmeschicht (16) jeder Mesa M₍₀₎ einen Maschenparameter a^{e}_{cre(0)} kleiner als a^{e}_{cre(N)} aufweist;
∘ wobei die Epitaxie-Aufnahmeschicht (16) jeder Mesa M₍ₙ₎ einen Zwischennetzparameter a^{e}_{cre(n)} kleiner als a^{e}_{cre(N)} und ungleich a^{e}_{cre(0)} aufweist.

3. Wachstumssubstrat (10) nach Anspruch 1 oder 2, wobei die Isolierzwischenschicht (14) jeder Mesa eine geringere Dicke aufweist als die benachbarten dotierten Schichten (13, 15).

4. Wachstumssubstrat (10) nach Anspruch 3, wobei die Isolierzwischenschicht (14) jeder Mesa eine Dicke zwischen 10 nm und 100 nm aufweist.

5. Wachstumssubstrat (10) nach einem der Ansprüche 1 bis 4, wobei die untere Isolierschicht (12) und die Isolierzwischenschicht (14) einen Dotierungsgrad aufweisen, der höchstens 5x10¹⁷ cm⁻³ beträgt.

6. Wachstumssubstrat (10) nach einem der Ansprüche 1 bis 5, wobei die dotierten Schichten (13, 15) n-dotiert sind.

7. Wachstumssubstrat (10) nach einem der Ansprüche 1 bis 6, wobei die unteren dotierten Schichten (13) der Mesas M₍ᵢ₎ aus dem gleichen Material hergestellt sind und die gleiche Dicke von Mesa zu Mesa aufweisen; die Isolierzwischenschichten (14) der Mesas M₍ᵢ₎ werden aus dem gleichen Material hergestellt und weisen die gleiche Dicke von Mesa zu Mesa auf; und die oberen dotierten Schichten (15) der Mesas M₍ᵢ₎ sind aus dem gleichen Material hergestellt und weisen die gleiche Dicke von Mesa zu Mesa auf.

8. Optoelektronische Vorrichtung (1), umfassend: ein Wachstumssubstrat (10) nach einem der vorhergehenden Ansprüche; und eine Dioden D₍ᵢ₎-Matrix auf InGaN-Basis, epitaxiert von den Mesas des Wachstumssubstrats (10), wobei die Dioden geeignet sind, Lichtstrahlung bei verschiedenen Wellenlängen zu emittieren oder zu detektieren, wobei die Wellenlänge sich von einer Mesaskategorie M₍ᵢ₎ zur anderen unterscheidet.

9. Optoelektronische Vorrichtung 1 nach Anspruch 8, die einen RGB-Mikrobildschirm bildet, in dem die Dioden D₍ᵢ₎ Leuchtdioden sind, die so eingerichtet sind, dass sie eine Lichtstrahlung mindestens in Blau und Rot aussenden.

10. Herstellungsverfahren für ein Wachstumssubstrat (10) nach einem der Ansprüche 1 bis 7, umfassend folgende Schritte:
∘ Bestimmung eines Wertes einer elektrischen Spannung, die bei einem späteren Schritt der elektrochemischen Porosifizierung anzulegen ist;
∘ Herstellung eines kristallinen Stapels (20), umfassend, von unten nach oben: eine untere durchgehende Isolierschicht (22), die aus einem kristallinen Material auf GaN-Basis hergestellt ist, die bei dem vorbestimmten Wert der anzulegenden elektrischen Spannung nicht porosierbar ist; N dotierte durchgehende Schichten (23, 25), mit N≥2, die aus kristallinen Materialien auf GaN-Basis hergestellt sind, die bei dem vorbestimmten Wert der anzulegenden elektrischen Spannung porosierbar sind; mindestens eine durchgehende Isolierzwischenschicht (24), die die durchgehenden dotierten Schichten (23, 25) paarweise trennt, die aus einem kristallinen Material auf GaN-Basis hergestellt ist und, die bei dem vorbestimmten Wert der anzulegenden elektrischen Spannung nicht porosierbar ist;
∘ lokalisiertes Ätzen des kristallinen Stapels (20), um die Mesas M₍ᵢ₎ zu bilden;
∘ Herstellung mehrerer Elektroden (3), in Kontakt mit den zu porosifizierenden dotierten Schichten (13,15) nach den verschiedenen Mesaskategorien M₍ᵢ₎;
∘ gleichzeitige elektrochemische Porosifizierung der zu porosifizierenden dotierten Schichten (13, 15) durch Anwendung des vorbestimmten Wertes der elektrischen Spannung auf die zu porosifizierenden dotierten Schichten (13, 15).

11. Herstellungsverfahren nach Anspruch 10, wobei das Material der unteren durchgehenden Isolierschicht (22) und das Material der mittleren durchgehenden Isolierschicht (24) einen Dotierungsgrad aufweisen, der unter einem vordefinierten Mindestwert liegt, ab dem sie unter Berücksichtigung des vorbestimmten Werts der während des Porosifizierungsschritts angelegten elektrischen Spannung porosifiziert werden können.

12. Herstellungsverfahren nach Anspruch 10 oder 11, umfassend folgende Schritte:
∘ im Anschluss an den Porosifizierungsschritt, Entfernen der Elektroden (3) und anschließendes ordnungsgemäßes Aufbringen einer dünnen Isolierschicht (4), die die Mesas bedeckt;
∘ Ablagerung einer dicken Füllschicht (5), die die Lücken zwischen den Mesas füllt, und Verdünnung der dicken Füllschicht (5), so dass ein oberer Teil der dünnen Isolierschicht (4) frei wird, der eine obere Oberfläche der Mesas M₍ᵢ₎ bedeckt;
∘ selektives Ätzen des oberen Teils der dünnen isolierenden Füllschicht (5), selektiv an den Mesas M₍ᵢ₎, wodurch die obere Oberfläche frei wird.

13. Herstellungsverfahren nach einem der Ansprüche 10 bis 12, wobei der kristalline Stapel (20) eine durchgehende Epitaxie-Aufnahmeschicht (26) auf InGaN-Basis umfasst, die auf einer oberen dotierten durchgehenden Schicht (25) unter den N dotierten durchgehenden Schichten (23, 25) ruht.

14. Herstellungsverfahren nach einem der Ansprüche 10 bis 12, wobei nach dem Porosifizierungsschritt eine Epitaxie-Aufnahmeschicht (16) auf InGaN-Basis auf einer oberen dotierten Schicht (15) aus den N dotierten Schichten (13, 15) jeder Mesa M₍ᵢ₎ hergestellt wird.

15. Herstellungsverfahren einer optoelektronischen Vorrichtung nach einem der Ansprüche 8 und 9, umfassend folgende Schritte:
∘ Herstellung des Wachstumssubstrats durch das Verfahren nach einem der Ansprüche 10 bis 14; anschließend
∘ Herstellung einer Dioden D₍ᵢ₎-Matrix durch Epitaxie aus den Mesas M₍ᵢ₎ des Wachstumssubstrats (10), wobei die Dioden dann geeignet sind, eine Lichtstrahlung bei verschiedenen Wellenlängen auszusenden oder zu detektieren, wobei die Wellenlänge sich von einer Mesaskategorie M₍ᵢ₎ zur anderen unterscheidet.

## Claims

1. Growth substrate (10), adapted to produce by epitaxy an array of diodes based on InGaN, comprising:
∘ a lower insulation layer (12) made of a non-porous crystalline material based on GaN;
∘ mesas M₍ᵢ₎, where i ranges from 0 to N, made of crystalline materials based on GaN, resting on and in contact with the lower insulation layer (12), and each comprising N doped layers (13, 15), where N≥2, separated pairwise by an intermediate insulation layer (14) made of a non-porous material, and each having a free upper face adapted for producing a diode of the array by epitaxy; the mesas being configured according to at least three different categories including:
• a category of mesas called M_{(N)} where the N doped layers (13, 15) are porous;
• a category of mesas called M₍₀₎ where none of the doped layers (13, 15) are porous;
• a category of mesas called M₍ₙ₎ where n doped layers (13, 15) are porous, where 1≤n<N.

2. Growth substrate (10) according to claim 1, wherein each mesa M₍ᵢ₎ includes an epitaxial regrowth layer (16) resting on an upper doped layer (15) among the N doped layers (13, 15), made of a non-porous crystalline material based on InGaN, the mesh parameter a^{m}_{cre} of the relaxed material of which is greater than the effective mesh parameter a^{e}_{cii} of the lower insulation layer (12):
∘ the epitaxial regrowth layer (16) of each mesa M_{(N)} having a maximum mesh parameter a^{e}_{cre(N)};
∘ the epitaxial regrowth layer (16) of each mesa M₍₀₎ having a mesh parameter a^{e}_{cre(0)} less than a^{e}_{cre(N)},
∘ the epitaxial regrowth layer (16) of each mesa M₍ₙ₎ having an intermediate mesh parameter a^{e}_{cre(n)} less than a^{e}_{cre(N)} and different from a^{e}_{cre(0)}.

3. Growth substrate (10) according to claim 1 or 2, wherein the intermediate insulation layer (14) of each mesa has a thickness less than that of the adjacent doped layers (13, 15).

4. Growth substrate (10) according to claim 3, wherein the intermediate insulation layer (14) of each mesa has a thickness between 10nm and 100nm.

5. Growth substrate (10) according to any one of claims 1 to 4, wherein the lower insulation layer (12) and the intermediate insulation layer (14) have a doping level at most equal to 5x10¹⁷ cm⁻³.

6. Growth substrate (10) according to any one of claims 1 to 5, wherein the doped layers (13, 15) are n-type doped.

7. Growth substrate (10) according to any one of claims 1 to 6, wherein the lower doped layers (13) of the mesas M₍ᵢ₎ are made of the same material and have the same thickness from one mesa to another; the intermediate insulation layers (14) of the mesas M₍ᵢ₎ are made of the same material and have the same thickness from one mesa to the other; and the upper doped layers (15) of the mesas M₍ᵢ₎ are made of the same material and have the same thickness from one mesa to another.

8. Optoelectronic device (1) comprising: a growth substrate (10) according to any one of the preceding claims; and an array of diodes D₍ᵢ₎ based on InGaN, grown epitaxially from the mesas of the growth substrate (10), the diodes being adapted to emit or detect a light radiation at different wavelengths, the wavelength being different from one category of mesas M₍ᵢ₎ to another.

9. Optoelectronic device 1 according to claim 8, forming an RGB microscreen where the diodes D₍ᵢ₎ are light-emitting diodes configured to emit a light radiation at least in blue and red.

10. Method for manufacturing a growth substrate (10) according to any one of claims 1 to 7, comprising the following steps:
∘ determining a value of an electrical voltage to be applied during a subsequent electrochemical porosification step;
∘ producing a crystalline stack (20), comprising, from bottom to top: a continuous lower insulation layer (22) made of a crystalline material based on GaN and non-porosifiable at said predetermined value of the electrical voltage to be applied; N continuous doped layers (23, 25), where N≥2, made of crystalline materials based on GaN and porosifiable at said predetermined value of the electrical voltage to be applied; at least one continuous intermediate insulation layer (24), separating the continuous doped layers (23, 25) pairwise, made of a crystalline material based on GaN and non-porosifiable at said predetermined value of the electrical voltage to be applied;
∘ localised etching of the crystalline stack (20), so as to form said mesas M₍ᵢ₎;
∘ producing several electrodes (3), in contact with the doped layers to be porosified (13, 15) according to the different categories of mesas M₍ᵢ₎;
∘ simultaneous electrochemical porosification of said doped layers to be porosified (13, 15), by applying to the doped layers to be porosified (13, 15) the predetermined value of the electrical voltage.

11. Manufacturing method according to claim 10, wherein the material of the lower continuous insulation layer (22) and the material of the intermediate continuous insulation layer (24) have a doping level less than a predefined minimum value from which they can be porosified given the predetermined value of the electrical voltage applied during the porosification step.

12. Manufacturing method according to claim 10 or 11, comprising the following steps:
∘ following the porosification step, removing the electrodes (3), following by conformal deposition of a thin insulating layer (4) covering the mesas;
∘ depositing a thick filler layer (5), filling the spaces between the mesas, and thinning the thick filler layer (5) so as to free an upper portion of the thin insulating layer (4) covering an upper surface of the mesas M₍ᵢ₎;
∘ selective etching of the upper portion of the thin insulating layer (5), selectively at the mesas M₍ᵢ₎, freeing the upper surface thereof.

13. Manufacturing method according to any one of claims 10 to 12, wherein the crystalline stack (20) comprises a continuous epitaxial regrowth layer (26) based on InGaN, relying on an upper continuous doped layer (25) among the N continuous doped layers (23, 25).

14. Manufacturing method according to any one of claims 10 to 12, wherein, after the porosification step, an epitaxial regrowth layer (16) based on InGaN is produced on an upper doped layer (15) among the N doped layers (13, 15) of each mesa M₍ᵢ₎.

15. Method for manufacturing an optoelectronic device according to any one of claims 8 and 9, comprising the following steps:
∘ manufacturing the growth substrate by the method according to any one of claims 10 to 14; then
∘ producing an array of diodes D₍ᵢ₎ by epitaxy from the mesas M₍ᵢ₎ of the growth substrate (10), the diodes then being adapted to emit or detect a light radiation at different wavelengths, the wavelength being different from one category of mesas M₍ᵢ₎ to another.
